# EUROPEAN PATENT APPLICATION

(11) **EP 4 753 434 A1**
(43) Date of publication of application: **03.06.2026**
(21) Application number: 24859967.2
(22) Date of filing: 30.08.2024
(51) Int. Cl.: H10N 15/00, H10B 61/00, H10D 48/40, H10N 50/80

(54) **THERMOELECTRIC CONVERSION ELEMENT, THERMOELECTRIC CONVERSION MODULE, AND THERMOELECTRIC CONVERSION METHOD**

(30) Priority: 31.08.2023 JP 2023141650; 20.08.2024 JP 2024139223
(71) Applicant: The University of Tokyo, Bunkyo-ku, Tokyo 113-8654 (JP); SUMITOMO CHEMICAL COMPANY, LIMITED, Tokyo 103-6020 (JP)
(72) Inventor: OKAMOTO, Satoshi, Tokyo 103-6020 (JP); SAITOH, Eiji, Tokyo 113-8654 (JP); KIKKAWA, Takashi, Tokyo 113-8654 (JP); HIRATA, Yuya, Tokyo 113-8654 (JP)
(74) Representative: J A Kemp LLP
(86) International application number: PCT/JP2024/031247
(87) International publication number: WO 2025/047942

(57) **Abstract**

A thermoelectric conversion element 200 of the present invention includes a thermoelectric conversion part 202 that has a nonlinear thermoelectric response characteristic for an input of a heat flux H in a first direction, and electrode parts 207a and 207b for extracting a thermoelectric signal J_{N} generated in the thermoelectric conversion part 202 due to the heat flux H input to the thermoelectric conversion part 202 from the outside in the first direction.

## Description

### Technical Field

The present invention relates to a thermoelectric conversion element, a thermoelectric conversion module, a thermoelectric conversion method, and a fluctuation detection sensor.

### Background Art

Energy harvesting (environmental power generation) technology for collecting various forms of energy from the surrounding environment and converting them into electrical energy is attracting attention. Known examples of such technology include thermoelectric conversion elements that utilize the Seebeck effect as described in PTL 1 and thermoelectric conversion elements that utilize the spin Seebeck effect as described in NPLs 1 and 2.

Detectors and sensors are also known which detect failures, accidents, or deterioration of objects (for example, device failure, building deterioration, or abnormal biological health) by measuring physical quantities such as specific frequencies, temperatures, and current values of substances. For example, PTL 2 discloses a fire detection device that detects the occurrence of a fire. This fire detection device includes a microphone that collects sound generated in a monitoring area as acoustic data, a frequency analysis unit that calculates a frequency spectrum by performing frequency analysis of the acoustic data collected by the microphone, and a fire detection unit that determines whether the frequency spectrum calculated by the frequency analysis unit includes a 1/f fluctuation characteristic in a frequency band below a standing wave, and detects that a fire has occurred in the monitoring area when it is determined that the frequency spectrum includes a 1/f fluctuation characteristic.

### Citation List

### Patent Literature

[Patent Literature 1] Japanese Unexamined Patent Application Publication No. 2015-144212
[Patent Literature 2] Japanese Patent No. 7376660

### Non-Patent Literature

[Non-Patent Literature 1] Kenichi Uchida, Eiji Saito, "Spin Seebeck Effect and Its Application to Thermoelectric Conversion", Applied Physics, Japan Society of Applied Physics, 2013, Vol. 82, No. 11, pp. 928-931
[Non-Patent Literature 2] K.Uchida, et. al., "Observation of the spinSeebeck effect", Nature, 2008, Vol. 455, No. 9, p.778-781

### Summary of Invention

### Technical Problem

Thermoelectric conversion elements using the Seebeck effect and the spinSeebeck effect, which are known in the related art, convert a temperature gradient generated in an object into electrical energy, and when the temperature gradient is reversed, the polarity of an electric field generated in the elements is also reversed. For this reason, the existence of a steady temperature gradient on a macroscale has been required for power generation. For this reason, it has been virtually impossible to perform thermoelectric conversion from a heat source in which the direction and magnitude of a heat flux change randomly, that is, from a temperature fluctuation on a microscale.

Detectors and sensors of the related art which detect failures, accidents, or deterioration can only detect the occurrence thereof when a failure, an accident, or deterioration actually occurs in an object due to the mechanism of measuring physical quantities such as specific frequencies, temperatures, and current values of substances. For this reason, the detectors and sensors of the related art could not detect signs thereof and prevent the occurrence thereof. If it is possible to detect when energy that inherently repeats a certain regular movement, such as vibration or electromagnetic noise emitted from an object, begins to move irregularly, it is considered that signs of a failure, an accident, or deterioration of the object can be captured. However, for this, it is necessary to detect fluctuations in which such energy changes randomly on a microscale. However, no sensor capable of detecting microscale energy fluctuations emitted from such an object is known.

The present invention has been made in view of the above-mentioned problems, and an object thereof is to provide a thermoelectric conversion element, a thermoelectric conversion module, and a thermoelectric conversion method which are capable of thermoelectric conversion from a temperature fluctuation on a microscale or to provide a sensor capable of detecting energy fluctuations on a microscale emitted from an object.

### Solution to Problem

In order to solve the above-mentioned problems, a thermoelectric conversion element according to the present invention includes a thermoelectric conversion part that has a nonlinear thermoelectric response characteristic for an input of a heat flux in a first direction, and an electrode part for extracting a thermoelectric signal generated in the thermoelectric conversion part due to the heat flux input to the thermoelectric conversion part from the outside in the first direction.

According to the thermoelectric conversion element of the present invention, the inventors have found that the thermoelectric signal generated in the thermoelectric conversion part by the flowing heat flux is nonlinear with respect to the direction of the heat flux due to the nonlinear thermoelectric response characteristic of the thermoelectric conversion part, and such a the nonlinear thermoelectric signal can be electrically extracted by the electrode part. For this reason, it is possible to generate a thermoelectric signal in a constant direction within the thermoelectric conversion part even from a heat flux that varies randomly in direction and magnitude, and thus thermoelectric conversion can be performed from a temperature fluctuation on a microscale.

In order to solve the above problem, in the thermoelectric conversion element according to the present invention, the thermoelectric conversion part may exhibit non-reciprocal conduction based on breaking of spatial inversion symmetry, the electrode part may comprise a pair of electrodes for extracting non-reciprocal thermoelectric signals, and the pair of electrodes may be provided in the thermoelectric conversion part so as to be spaced apart from each other.

Thereby, the inventors have found that the thermoelectric signal generated in the thermoelectric conversion part by a flowing heat flux is non-reciprocal with respect to the direction of the heat flux due to non-reciprocal conduction of the thermoelectric conversion part, and that the non-reciprocal thermoelectric signal can be electrically extracted by the pair of electrodes. For this reason, it is possible to generate a thermoelectric signal in a constant direction within the thermoelectric conversion part even from a heat flux that varies randomly in direction and magnitude, and thus thermoelectric conversion can be performed from a temperature fluctuation on a microscale.

Furthermore, in the thermoelectric conversion element according to the present invention, it is preferable that the thermoelectric conversion part be a thermoelectric conversion layer including a ferromagnetic metal layer and a paramagnetic metal layer stacked on each other in a second direction orthogonal to the first direction, and the pair of electrodes be provided in the thermoelectric conversion layer so as to be spaced apart from each other in the first direction in an in-plane direction of the thermoelectric conversion layer. Thereby, the voltage of thermoelectric conversion based on the breaking of spatial inversion symmetry of the thermoelectric conversion layer is increased, and thus the thermoelectric conversion efficiency is particularly increased.

Furthermore, in the thermoelectric conversion element according to the present invention, a separation distance between the pair of electrodes may be 0.1 µm or more and 1000 µm or less. By setting the separation distance in such a range, the voltage of thermoelectric conversion is increased, and thus the thermoelectric conversion efficiency is increased.

Furthermore, in the thermoelectric conversion element according to the present invention, it is preferable that the paramagnetic metal layer include a single layer or a plurality of stacked layers, and the single layer or each of the plurality of stacked layers of the paramagnetic metal layer include Pt, Pd, W, an AuW alloy, Ta, a CuIr alloy, a CuBi alloy, a BiSb alloy, or a BiSe alloy. Thereby, the irreciprocity of conduction based on the breaking of spatial inversion symmetry of the thermoelectric conversion layer is particularly increased, and thus the thermoelectric conversion efficiency is particularly increased.

Furthermore, in the thermoelectric conversion element according to the present invention, it is preferable that the ferromagnetic metal layer include a single layer or a plurality of stacked layers, and the single layer or each of the plurality of stacked layers of the ferromagnetic metal layer include a Ni-Fe alloy, Fe, CoNi, Gd, a CoFeB alloy, or a (Ga,Fe)Sb alloy. These are materials that exhibit ferromagnetism at room temperature, and the irreciprocity of conduction at room temperature is realized, leading to an increase in thermoelectric conversion efficiency.

Furthermore, a thermoelectric conversion module according to the present invention includes a plurality of the thermoelectric conversion elements according to any one of the above, and the plurality of thermoelectric conversion elements are electrically connected to each other so that thermoelectric signals from the thermoelectric conversion elements are able to be superimposed on each other with the same polarity. Thereby, it is possible to extract a large non-reciprocal thermoelectric signal.

In order to solve the above-mentioned problem, a thermoelectric conversion method according to the present invention includes a step of preparing a thermoelectric conversion element including a thermoelectric conversion layer exhibiting non-reciprocal conduction based on breaking of spatial inversion symmetry, and a pair of electrodes provided in the thermoelectric conversion layer so as to be spaced apart from each other to extract non-reciprocal thermoelectric signals, the thermoelectric conversion layer including a ferromagnetic metal layer and a paramagnetic metal layer stacked on each other, and the pair of electrodes being provided in the paramagnetic metal layer so as to be spaced apart from each other in an in-plane direction of the paramagnetic metal layer, and a step of performing thermoelectric conversion while applying a magnetic field of 1 T or less to the ferromagnetic metal layer of the thermoelectric conversion layer.

According to the thermoelectric conversion method of the present invention, when a heat flux flows into a stacked body of a ferromagnetic metal layer, which is magnetized by applying a magnetic field of 1 T or less, and a paramagnetic metal layer, a spin current is driven in the paramagnetic metal layer, and a spin accumulation is formed at an interface between the paramagnetic metal layer and the ferromagnetic metal layer. The polarity of the spin accumulation is parallel or antiparallel to the magnetization direction of the ferromagnetic metal layer, depending on the direction of the heat flux. The scattering of electrons changes depending on a relative direction between the polarity of the spin accumulation and the direction of the magnetization, and thus the thermoelectric signal generated in the thermoelectric conversion layer has dependence on direction of the heat flux, that is, irreciprocity. This is a non-reciprocal thermoelectric signal, which can be electrically extracted by a pair of electrodes. For this reason, it is possible to generate a thermoelectric signal in a constant direction within the paramagnetic metal layer even from a heat flux that varies randomly in direction and magnitude, and thus thermoelectric conversion can be performed from a temperature fluctuation on a microscale.

In order to solve the above-mentioned problem, a thermoelectric conversion method according to the present invention includes a step of applying a temperature gradient including an AC component to a thermoelectric conversion part that exhibits non-reciprocal conduction based on breaking of spatial inversion symmetry, and a step of causing the thermoelectric conversion part to generate a non-reciprocal thermoelectric signal by thermoelectric ally converting the temperature gradient including the AC component.

According to the thermoelectric conversion method of the present invention, the thermoelectric conversion part generates a thermoelectric signal by thermoelectrically converting a temperature gradient including an applied AC component. In this case, the thermoelectric signal is nonlinear with respect to the direction of the temperature gradient due to the non-reciprocal conduction characteristic of the thermoelectric conversion part, and thus becomes a non-reciprocal thermoelectric signal. Thereby, a temperature fluctuation on a microscale can be regarded as a temperature gradient including an AC component, and thus thermoelectric conversion can be performed from the temperature fluctuation on a microscale.

In order to solve the above-mentioned problem, a fluctuation detection sensor according to the present invention includes a nonlinear response part that has a nonlinear electrical response characteristic for an input of external energy in a first direction, and an electrode part for extracting an electrical response signal generated in the nonlinear response part due to an energy fluctuation input to the nonlinear response part from the outside in the first direction.

According to the fluctuation detection sensor of the present invention, the inventors have found that the electrical response signal generated in the nonlinear response part by the externally input energy fluctuation is non-reciprocal with respect to the direction of a flow of energy due to the nonlinear electrical response characteristic of the nonlinear response part, and such a non-reciprocal electrical response signal can be electrically extracted by the electrode part. For this reason, a nonlinear voltage signal, which is a non-reciprocal electrical response signal, can be generated in a constant direction within the nonlinear response part even from external energy that varies randomly in direction and magnitude, and thus it is possible to detect an energy fluctuation on a microscale which is emitted from an object.

Furthermore, in the fluctuation detection sensor according to the present invention, the external energy may be a current and/or a heat flux, and the energy fluctuation may be a current fluctuation and/or a heat flux fluctuation. In this case, it is possible to detect a current fluctuation and/or a heat flux fluctuation emitted from the object.

Furthermore, in the fluctuation detection sensor according to the present invention, the external energy may be a current, and the energy fluctuation may be a current fluctuation. In this case, it is possible to detect a current fluctuation emitted from the object.

Furthermore, in the fluctuation detection sensor according to the present invention, the nonlinear response part may have a configuration in which spatial inversion symmetry is broken along a second direction orthogonal to the first direction.

Furthermore, in the fluctuation detection sensor according to the present invention, the nonlinear response part may include a ferromagnetic layer and a paramagnetic layer which are stacked on each other along the second direction.

Furthermore, in the fluctuation detection sensor according to the present invention, the ferromagnetic layer may be configured to have spontaneous magnetization and/or a high coercive force.

Furthermore, in the fluctuation detection sensor according to the present invention, the ferromagnetic layer may be a ferromagnetic metal layer and may be made of an L1₀ type ordered alloy made of a magnetic metal and a paramagnetic metal, and the paramagnetic layer may be a paramagnetic metal layer. Thereby, it is possible to increase the magnitude of a coercive force that the ferromagnetic layer can have.

### Advantageous Effects of Invention

According to the present invention, a thermoelectric conversion element, a thermoelectric conversion module, and a thermoelectric conversion method which are capable of thermoelectric conversion from a temperature fluctuation on a microscale are provided, or a sensor capable of detecting energy fluctuations on a microscale emitted from an object is provided.

### Brief Description of Drawings

FIG. 1 is a perspective view showing a thermoelectric conversion element according to a first embodiment.
FIG. 2 is a cross-sectional view of the thermoelectric conversion element according to the first embodiment.
FIG. 3 is a flowchart showing steps of a thermoelectric conversion method according to the first embodiment.
FIG. 4 is a perspective view showing a configuration of a thermoelectric conversion module using the thermoelectric conversion element.
FIG. 5 is a schematic diagram showing an experimental method for measuring non-reciprocal thermoelectric signals.
FIG. 6 is a diagram showing measurement results of an experiment for measuring non-reciprocal thermoelectric signals.
FIG. 7 is a perspective view showing a fluctuation detection sensor according to a second embodiment.
FIG. 8 is a cross-sectional view of the fluctuation detection sensor according to the second embodiment.
FIG. 9 is a flowchart showing steps of an energy conversion method according to the second embodiment.
FIG. 10 is a perspective view showing the configuration of a fluctuation detection sensor module using the fluctuation detection sensor.
FIG. 11 is a schematic diagram showing an experimental method of measuring a non-reciprocal voltage signal J_{N1} in Example 3.
FIG. 12 is a diagram showing measurement results of an experiment in Example 3.
FIG. 13 is a schematic diagram showing an experimental method of measuring a non-reciprocal voltage signal J_{N1} in Example 4.
FIG. 14 is a diagram showing measurement results of an experiment in Example 4.

### Description of Embodiments

Hereinafter, embodiments of the present invention will be described in detail with reference to the accompanying drawings. In each drawing, the same reference numerals are used for the same elements where possible. Dimensional ratios within and between components in the drawings are arbitrary for ease of reading the drawings.

### (First Embodiment)

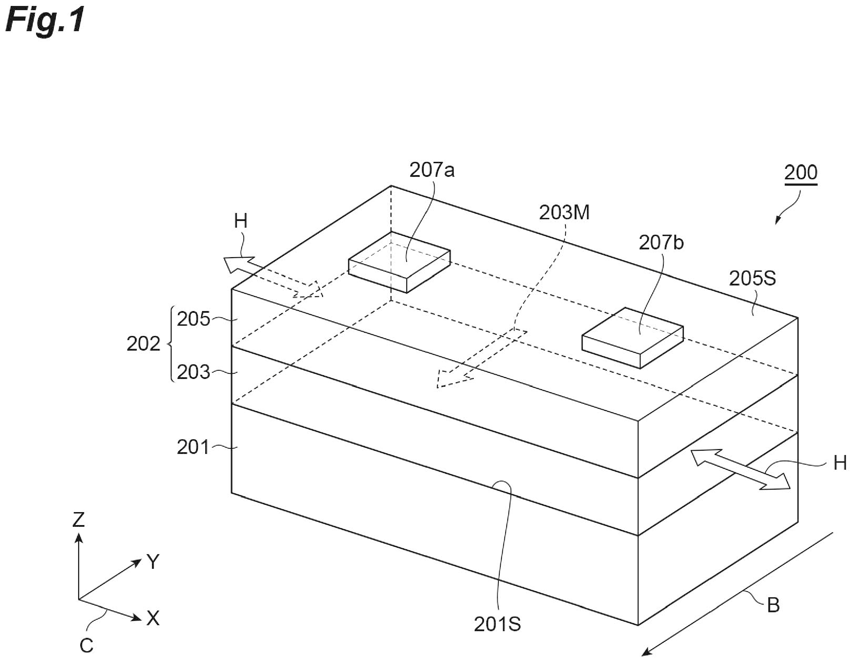

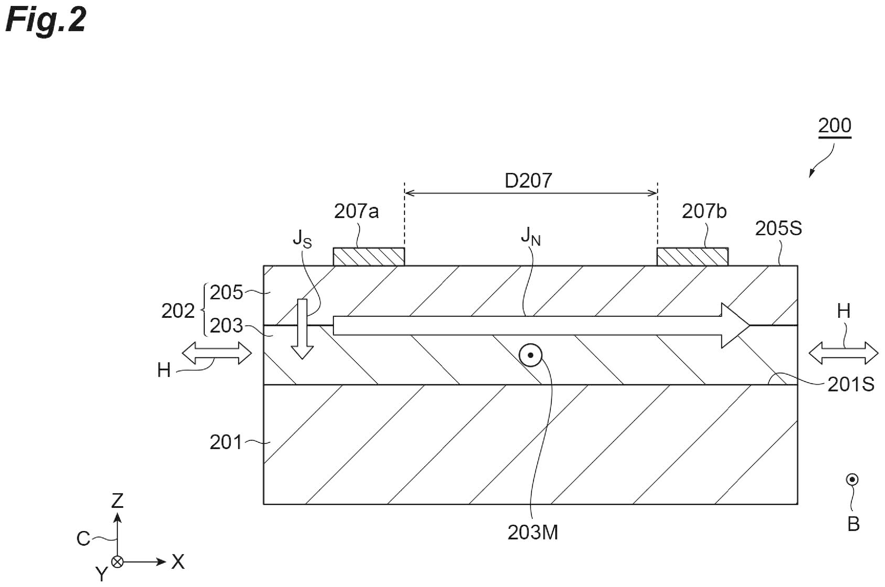

FIG. 1 is a perspective view showing a thermoelectric conversion element according to a first embodiment, and FIG. 2 is a cross-sectional view of the thermoelectric conversion element according to the first embodiment.

As shown in FIGS. 1 and 2, a thermoelectric conversion element 200 in the present embodiment includes a substrate 201, a thermoelectric conversion layer 202 as a thermoelectric conversion part, and a pair of electrodes 207a and 207b as electrode parts.

The substrate 201 is, for example, a plate-like or film-like member as shown in FIG. 1, and has a substantially flat surface 201S. The surface 201S has, for example, a rectangular shape when viewed from a Z-axis direction as shown in FIG. 1. The substrate 201 is a member for stacking the thermoelectric conversion layer 202 on the surface 201S. Examples of the material constituting the substrate 201 include metals such as Au, Ag, Cu, and Al, silicon, sapphire, SiC, GaN, yttria stabilized zirconia (YSZ), and resins such as polyimide, polyethylene terephthalate (PET), and polyethylene naphthalate (PEN).

FIGS. 1 and 2 show an orthogonal coordinate system C in which a Z-axis is set in the thickness direction of the substrate 201, and an X-axis and a Y-axis are set in the long side and short side directions, respectively, of the rectangle of the surface 201S of the substrate 201. Also in the subsequent drawings, the orthogonal coordinate system C is shown where necessary.

The thermoelectric conversion layer 202 includes a single-layer ferromagnetic metal layer 203 and a single-layer paramagnetic metal layer 205 stacked on each other in the Z-axis direction (second direction). In this embodiment, the ferromagnetic metal layer 203 is stacked on the surface 201S of the substrate 201, and the paramagnetic metal layer 205 is stacked on the ferromagnetic metal layer 203. The ferromagnetic metal layer 203 is made of a metal that exhibits ferromagnetism at temperatures in the use environment of the thermoelectric conversion element 200. The ferromagnetic metal layer 203 is preferably made of a metal that exhibits ferromagnetism at room temperature (approximately 300 K). From this viewpoint, it is preferable that the ferromagnetic metal layer 203 be made of Fe, Co, Ni, Gd, or an alloy containing at least one of them, and it is particularly preferable that the ferromagnetic metal layer 203 be made of a Ni-Fe alloy, Co, or CoFeB.

The thermoelectric conversion layer 202 has, for example, a rectangular shape in plan view (that is, viewed from the Z-axis direction) with a long side in the X-axis direction and a short side in the Y-axis direction. The thickness of the ferromagnetic metal layer 203 is not particularly limited, but may be, for example, 1 nm or more and 100 nm or less.

The paramagnetic metal layer 205 is made of a metal that exhibits paramagnetism at temperatures in the use environment of the thermoelectric conversion element 200, and is preferably made of a metal that exhibits paramagnetism at room temperature (300 K). The paramagnetic metal layer 205 is preferably made of a paramagnetic metal with high spin-orbit interaction in order to enhance the spin Nernst effect in the paramagnetic metal layer 205, which will be described later. From this viewpoint, it is preferable that the paramagnetic metal layer 205 be made of Pt, Pd, W, an AuW alloy, Ta, a CuIr alloy, a CuBi alloy, a BiSb alloy, or a BiSe alloy, and it is particularly preferable that the paramagnetic metal layer 205 be made of Pt. The thickness of the paramagnetic metal layer 205 is not particularly limited, but may be, for example, 1 nm or more and 100 nm or less.

The thermoelectric conversion layer 202 exhibits non-reciprocal conduction based on the breaking of spatial inversion symmetry. Specifically, although a paramagnetic metal layer is provided on the surface of the ferromagnetic metal layer 203, no similar paramagnetic metal layer is provided on the back surface of the ferromagnetic metal layer 203, and a ferromagnetic metal layer is provided on the back surface of the paramagnetic metal layer 205, but no similar ferromagnetic metal layer is provided on the surface of the paramagnetic metal layer 205. For this reason, the thermoelectric conversion layer 202 has a structure with the breaking of spatial inversion symmetry along the Z-axis direction. The thermoelectric conversion layer 202 has substantial spatial inversion symmetry in directions along the XY plane. The thermoelectric conversion layer 202 exhibits irreciprocity with respect to electrical conductivity in the in-plane (in the XY plane) direction due to this breaking of spatial inversion symmetry along the Z-axis direction. Thereby, the thermoelectric conversion layer 202 has a nonlinear thermoelectric response characteristic to an input of a heat flux H along one of the in-plane (in the XY plane) directions (in this embodiment, the X-axis direction as a first direction), as described below.

The pair of electrodes 207a and 207b are provided in the thermoelectric conversion layer 202 so as to be spaced apart from each other in the in-plane (in the XY plane) direction of the thermoelectric conversion layer 202. The pair of electrodes 207a and 207b are provided to extract a thermoelectric signal J_{N} generated in the thermoelectric conversion layer 202 due to the heat flux H that is input to the thermoelectric conversion layer 202 from the outside in one of the in-plane (in the XY plane) directions as described below. In this embodiment, the pair of electrodes 207a and 207b are provided in the paramagnetic metal layer 205 so as not to be in contact with the ferromagnetic metal layer 203, and are provided on a surface 205S on the side opposite to the ferromagnetic metal layer 203 of the paramagnetic metal layer 205. The pair of electrodes 207a and 207b are spaced apart from each other along the X-axis direction, which is one of the in-plane (in the XY plane) directions of the paramagnetic metal layer 205. The pair of electrodes 207a and 207b are made of a material having a conductivity capable of extracting a non-reciprocal thermoelectric signal from the thermoelectric conversion layer 202 as described below. Examples of such a material include metal materials, such as Cu, Ag, Au, Pt, Ni, Al, constantan, Cr, In, Pd, Fe, a Cu alloy, a Ti/Au laminate, and a Cr/Au laminate, and conductive oxides such as indium tin oxide (ITO) and zinc oxide (ZnO). Cu, Ag, Au, Pt, Ni, Al, constantan, and a Cu alloy are preferable, and Cu, Au, Ag, Pt, Ni, a Ti/Au laminate, and a Cr/Au laminate are particularly preferable.

The thicknesses of the pair of electrodes 207a and 207b are not particularly limited, but may be, for example, 10 nm or more and 1 µm or less. A separation distance D207 between the pair of electrodes 207a and 207b along the X-axis direction is preferably 0.1 µm or more and 1000 µm or less.

The thermoelectric conversion element 200 of this embodiment may include a layer made of an electrically insulating magnetic material provided in contact with the ferromagnetic metal layer 203, or may not include a layer made of such an insulating magnetic material.

To manufacture such a thermoelectric conversion element 200, for example, the substrate 201 is prepared, a material for forming the ferromagnetic metal layer 203 and a material for forming the paramagnetic metal layer 205 are deposited in this order on the surface 201S thereof by a physical vapor deposition method such as a DC magnetron sputtering method to form a stacked body, and the thermoelectric conversion layer 202 is formed by patterning the stacked body into a rectangular shape in plan view by a photolithography method and a lift-off method. Thereafter, a metal material for forming the pair of electrodes 207a and 207b is deposited in a region including the surface 205S of the paramagnetic metal layer 205 by a physical vapor deposition method such as a DC magnetron sputtering method to form a metal layer, and the metal layer is patterned into a predetermined shape by a photolithography method and a lift-off method so as to form the pair of electrodes 207a and 207b.

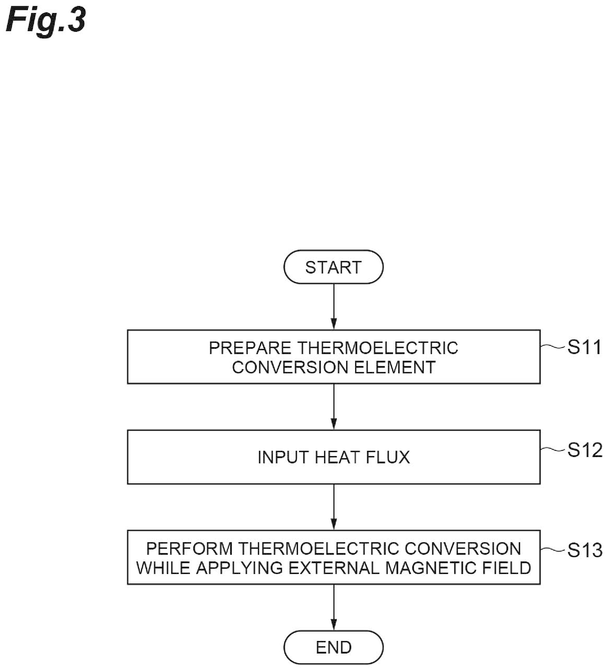

Next, a thermoelectric conversion method according to this embodiment will be described. FIG. 3 is a flowchart showing steps of the thermoelectric conversion method according to this embodiment. As shown in FIG. 3, the steps of the thermoelectric conversion method according to this embodiment include step S11 of preparing a thermoelectric conversion element, step S12 of inputting a heat flux, and step S13 of performing thermoelectric conversion while applying an external magnetic field. These steps will be described with reference to FIGS. 1 and 2 again.

In step S11 of preparing the thermoelectric conversion element, the thermoelectric conversion element 200 described above is prepared as shown in FIGS. 1 and 2. Next, in step S12 of inputting a heat flux, a heat flux H is applied to the thermoelectric conversion layer 202, which exhibits non-reciprocal conduction based on the breaking of spatial inversion symmetry. Specifically, in step S12 of inputting a heat flux, the heat flux H from the outside, which is an object of thermoelectric conversion, is input to the thermoelectric conversion layer 202 so as to flow along the X-axis direction, which is one of the in-plane (in the XY plane) directions of the thermoelectric conversion layer 202.

The heat flux H in this embodiment corresponds to the "temperature fluctuation on a microscale" described above. The heat flux H is a temperature gradient including a single or a plurality of AC components. Here, an "AC component" is a component whose heat magnitude periodically fluctuates positively or negatively at a predetermined frequency. When the heat flux H includes a plurality of AC components, the frequencies of respective AC components are different from each other. As described above, the "temperature fluctuation on a microscale" corresponds to a heat source in which the direction and magnitude of the heat flux changes randomly, but since a single AC component or a plurality of AC components with different frequencies, which are included in the temperature fluctuation, can be obtained by Fourier transform, the "temperature fluctuation on a microscale" described above can be regarded as a temperature gradient including a single or a plurality of AC components.

Next, step S13 of performing thermoelectric conversion while applying an external magnetic field is performed. Step S13 of performing thermoelectric conversion while applying an external magnetic field includes a step in which the thermoelectric conversion layer 202 thermoelectrically converts the heat flux H to generate a thermoelectric signal J_{N}. Specifically, in step S13 of performing thermoelectric conversion while applying an external magnetic field, an external magnetic field B generated from a magnetic field generation part provided outside the thermoelectric conversion element 200 is applied to the ferromagnetic metal layer 203. The direction of application of the external magnetic field B is a negative Y-axis direction, which is an in-plane (in the XY plane) direction of the thermoelectric conversion element 200 and is one of the directions orthogonal to the direction of the flow of the heat flux H. Thereby, the ferromagnetic metal layer 203 is magnetized in the direction of the external magnetic field B and has magnetization 203M oriented in the direction of the external magnetic field B. The application of such an external magnetic field B is maintained during the thermoelectric conversion of the heat flux H. The magnitude of the external magnetic field B can be, for example, 1 T or less.

In step S13, when the heat flux H flows into the paramagnetic metal layer 205, a spin current Js is generated in the Z-axis direction and flows into the ferromagnetic metal layer 203. The polarity of the spin current J_{S} changes in the positive or negative Y-axis direction depending on the direction of the heat flux H. For this reason, when the direction of the heat flux H is reversed, the polarity of the spin current J_{S} is reversed, and a relative direction relationship between the polarity of the spin current J_{S} and the direction of the magnetization 203M of the ferromagnetic metal layer 203 is reversed. By reversing the direction of the magnetization 203M of the ferromagnetic metal layer 203, the relative direction relationship between the polarity of the spin current J_{S} and the direction of the magnetization 203M can also be reversed.

When the spin current J_{S} flows into the ferromagnetic metal layer 203, electron scattering changes depending on the relative direction of the polarity direction of the spin current and the direction of the magnetization 203M of the ferromagnetic metal layer 203. Since the polarity direction of the spin current near a junction interface between the ferromagnetic metal layer 203 and the paramagnetic metal layer 205 changes depending on the direction of the heat flux H, this electron scattering changes depending on the direction of the heat flux H. Thereby, the thermoelectric signal generated in the thermoelectric conversion layer 202 has a dependence on direction of the heat flux H, that is, irreciprocity.

The thermoelectric signal J_{N} generated in the thermoelectric conversion layer 202 is non-reciprocal to the direction of the heat flux H (that is, a thermoelectric signal J_{N} changes nonlinearly with respect to the direction of the heat flux H) due to the non-reciprocal conduction of the thermoelectric conversion layer 202 as described above. The inventors of the present application have found that the direction of the thermoelectric signal J_{N} is in the positive X-axis direction regardless of whether the direction of the heat flux H is in the positive X-axis direction or the negative X-axis direction, and that such a non-reciprocal thermoelectric signal J_{N} can be electrically extracted via the pair of electrodes 207a and 207b. For this reason, according to the thermoelectric conversion element 200 of this embodiment, even when the direction and magnitude of the heat flux H randomly changes, the non-reciprocal thermoelectric signal J_{N} can be generated in a constant direction in the thermoelectric conversion layer 202, and thus thermoelectric conversion can be performed from a temperature fluctuation on a microscale.

By inverting the direction of the external magnetic field B in the positive Y-axis direction and inverting the direction of the magnetization 203M of the ferromagnetic metal layer 203 in the positive Y-axis direction, the direction of the non-reciprocal thermoelectric signal J_{N} can be inverted in the negative X-axis direction.

In the thermoelectric conversion layer 202, the magnitude of the voltage of the non-reciprocal thermoelectric signal J_{N} extracted by the pair of electrodes 207a and 207b is V, the electric field generated in the thermoelectric conversion layer 202 corresponding to V is E, the nonlinear Seebeck coefficient of the thermoelectric conversion layer 202 is S, a distance between the pair of electrodes 207a and 207b is L (D207 in FIG. 2), a temperature gradient in the range of the distance L of the thermoelectric conversion layer 202 is VT, and a temperature difference in the range of the distance L of the thermoelectric conversion layer 202 is ΔT, the relation of Electric field E = Nonlinear Seebeck coefficient S × (temperature gradient ∇T)² is established. By multiplying both sides of this formula by the distance L, the relation of Voltage V = Nonlinear Seebeck coefficient S x (temperature difference ΔT)²/L is established, and thus the smaller the distance L between the pair of electrodes 207a and 207b, the larger the voltage V. For this reason, by setting the separation distance D207 in the X-axis direction between the pair of electrodes 207a and 207b to a small value, preferably 1000 µm or less, as described above, the non-reciprocal thermoelectric signal J_{N} extracted by the pair of electrodes 207a and 207b becomes larger.

The thermoelectric conversion element 200 may also be provided with a heat conduction part that is provided in contact with or in close proximity to an end face on the positive X-axis side and/or an end face on the negative X-axis side to facilitate the flow of the heat flux H into the thermoelectric conversion layer 202. Such a heat conduction part can be made of, for example, aluminum, copper, carbon fiber, sapphire, alumina, silicon with a thermal oxide film, or a polymer.

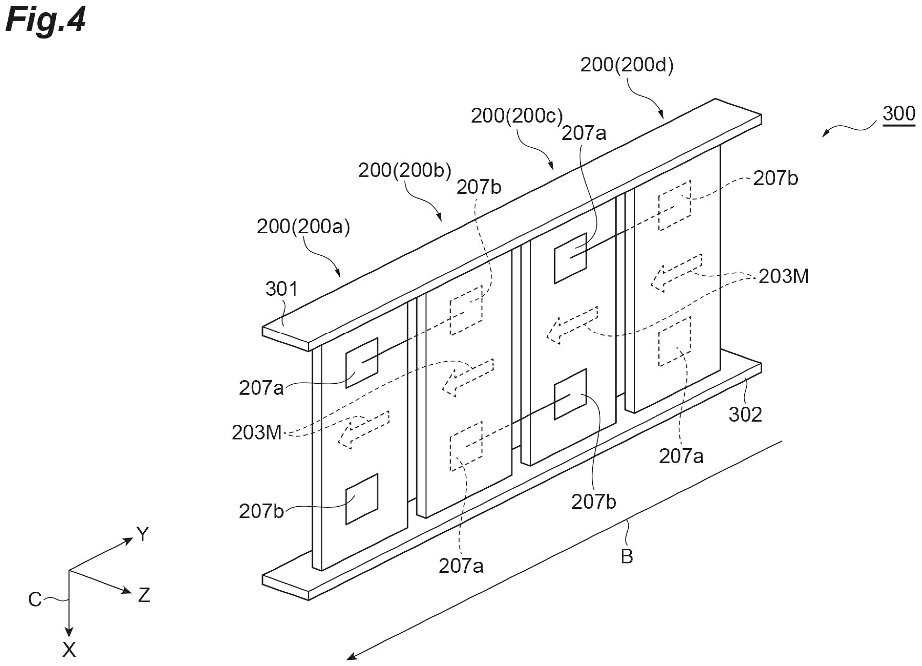

FIG. 4 is a perspective view showing the configuration of a thermoelectric conversion module using the above-described thermoelectric conversion element. As shown in FIG. 4, a thermoelectric conversion module 300 according to this embodiment includes a plurality of thermoelectric conversion elements 200, and in this embodiment, includes four thermoelectric conversion elements 200a, 200b, 200c, and 200d in this embodiment. The four thermoelectric conversion elements 200a, 200b, 200c, and 200d are electrically connected to each other so that non-reciprocal thermoelectric signals J_{N} from each of the thermoelectric conversion elements are superimposed on each other with the same polarity.

Specifically, in the thermoelectric conversion module 300, the thermoelectric conversion elements 200a and 200c, which are disposed with respect to the orthogonal coordinate system C in a manner similar to the thermoelectric conversion element 200 shown in FIGS. 1 and 2, and the thermoelectric conversion elements 200b and 200d, which are disposed with respect to the orthogonal coordinate system C in a manner that rotates the thermoelectric conversion element 200 shown in FIGS. 1 and 2 by 180 degrees around the Y-axis, are provided alternately in the Y-axis direction. Then, the electrode 207a of the thermoelectric conversion element 200a and the electrode 207b of the thermoelectric conversion element 200b are electrically connected to each other, the electrode 207a of the thermoelectric conversion element 200b and the electrode 207b of the thermoelectric conversion element 200c are electrically connected to each other, and the electrode 207a of the thermoelectric conversion element 200c and the electrode 207b of the thermoelectric conversion element 200d are electrically connected to each other. Instead of disposing the thermoelectric conversion elements 200b and 200d in a manner that they are rotated by 180 degrees around the Y-axis, the thermoelectric conversion elements 200b and 200d may be disposed, like the thermoelectric conversion elements 200a and 200c, in the same manner as the thermoelectric conversion element 200 shown in FIGS. 1 and 2 with respect to the orthogonal coordinate system C, and then the stacking order of the ferromagnetic metal layer 203 and the paramagnetic metal layer 205 of the thermoelectric conversion layer 202 can be reversed in the thermoelectric conversion elements 200b and 200d. In this case, the electrode 207a of the thermoelectric conversion element 200a and the electrode 207a of the thermoelectric conversion element 200b are electrically connected to each other, the electrode 207b of the thermoelectric conversion element 200b and the electrode 207b of the thermoelectric conversion element 200c are electrically connected to each other, and the electrode 207a of the thermoelectric conversion element 200c and the electrode 207a of the thermoelectric conversion element 200d are electrically connected to each other.

The ferromagnetic metal layer 203 of each of the four thermoelectric conversion elements 200a, 200b, 200c, and 200d is magnetized in the negative Y-axis direction by the external magnetic field B, and has magnetization 203M oriented in the negative Y-axis direction.

The thermoelectric conversion module 300 also includes heat conduction parts 301 and 302 provided in contact with or in close proximity to the end faces on the negative X-axis and positive X-axis sides of the four thermoelectric conversion elements 200a, 200b, 200c, and 200d. Thereby, a heat flux flowing in the X-axis direction easily flows into the respective ferromagnetic metal layers 203 of the four thermoelectric conversion elements 200a, 200b, 200c, and 200d. The thermoelectric conversion module 300 may not include the heat conduction parts 301 and 302.

Non-reciprocal thermoelectric signals generated in the respective thermoelectric conversion elements 200 by the heat flux flowing into the respective ferromagnetic metal layers 203 of the four thermoelectric conversion elements 200a, 200b, 200c, and 200d can be superimposed on each other with the same polarity and then extracted by the electrode 207b of the thermoelectric conversion element 200a and the electrode 207a of the thermoelectric conversion element 200d. For this reason, it is possible to extract large non-reciprocal thermoelectric signals.

### (Examples)

Next, an example will be used to further clarify the effects of the invention according to the first embodiment. An element corresponding to the thermoelectric conversion element 200 was manufactured as follows. First, a 0.5 mm-thick Si substrate with a thermal oxide film was prepared as the substrate 201, and a Ni-Fe alloy layer with a thickness of 5 nm as the ferromagnetic metal layer 203 and a Pt layer with a thickness of 5 nm as the paramagnetic metal layer 205 were deposited on the substrate by a DC magnetron sputtering method in this order to form the thermoelectric conversion layer 202. Then, the thermoelectric conversion layer 202 was patterned into a rectangular shape in plan view with a width of 5 µm in the Y-axis direction and a length of 50 µm in the X-axis direction by photolithography and lift-off methods. Then, a Ti/Au layer was deposited on the thermoelectric conversion layer 202 by an RF magnetron sputtering method, and the Ti/Au layer was patterned into a predetermined shape by photolithography and lift-off methods to form a pair of electrodes corresponding to the pair of electrodes 207a and 207b, thereby manufacturing an element corresponding to the thermoelectric conversion element 200.

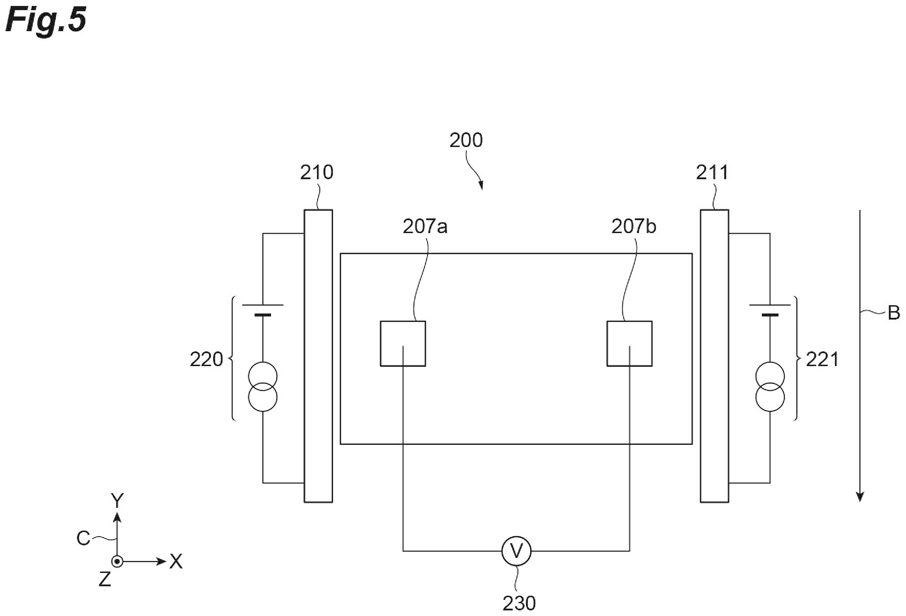

Next, the element was subjected to an experiment in which step S12 of inputting a heat flux and step S13 of performing thermoelectric conversion while applying an external magnetic field were performed at room temperature (300 K), and non-reciprocal thermoelectric signals J_{N} output from the pair of electrodes 207a and 207b were measured. FIG. 5 is a schematic diagram showing an experimental method for measuring non-reciprocal thermoelectric signals J_{N}. As shown in FIG. 5, a first resistor heater 210 was provided adjacent to the end of the element in the negative X-axis direction corresponding to the thermoelectric conversion element 200, and a second resistor heater 211 was provided adjacent to the end of the element in the positive X-axis direction. A first power supply 220 and a second power supply 221 were electrically connected to the first resistor heater 210 and the second resistor heater 211, respectively. A lock-in amplifier 230 was electrically connected between the pair of electrodes 207a and 207b.

Then, while varying the magnitude of the external magnetic field B applied to the thermoelectric conversion element 200 in the negative Y-axis direction from 5 mT to -5 mT in 0.1 mT increments, an AC temperature gradient ΔT_{AC}, which varies sinusoidally with an angular frequency ω in a direction along the X-axis, was applied to the thermoelectric conversion element 200 by the first resistor heater 210 and the second resistor heater 211. Then, among the thermoelectric signals generated by the thermoelectric conversion element 200, ΔV_{2ω}, _{y}, which is a y component of a variation in a thermoelectric signal corresponding to twice the frequency of the AC temperature gradient ΔT_{AC}, was detected by the lock-in amplifier 230.

More specifically, regarding the AC temperature gradient ΔT_{AC}, when ω represents an angular frequency and t represents a time, an AC voltage of V_{dc} + V_{ac}sin (ωt) was applied to the first resistor heater 210 by the first power supply 220, while an AC voltage of V_{dc} - V_{ac}sin (ωt), which is in the opposite phase thereto, was applied to the second resistor heater 211 by the second power supply 221. Thereby, an AC temperature gradient expressed as ΔT_{AC} = (√2)ΔTᵣₘₛsin(ωt) was applied to the thermoelectric conversion element 200 in the direction along the X-axis (ΔTᵣₘₛ is an effective value of the AC temperature gradient). For this reason, the AC temperature gradient ΔT_{AC} corresponds to a heat flux H including a single AC component. A voltage source device WF1968 manufactured by NF Corporation was used as the first power supply 220 and the second power supply 221, and a lock-in amplifier LI5640 manufactured by NF Corporation was used as the lock-in amplifier 230. The frequency f(= ω / 2 π) of the AC voltage applied by the first power supply 220 and the second power supply 221 was set to 13.723 Hz, and the above-mentioned V_{ac} was adjusted such that the above-mentioned ΔTᵣₘₛ was 4 K. As the lock-in conditions for the lock-in amplifier 230, a dynamic reserve was set to "low", a measurement sensitivity was set to 500 nV, a time constant was set to 1 second, and a slope was set to -24 dB.

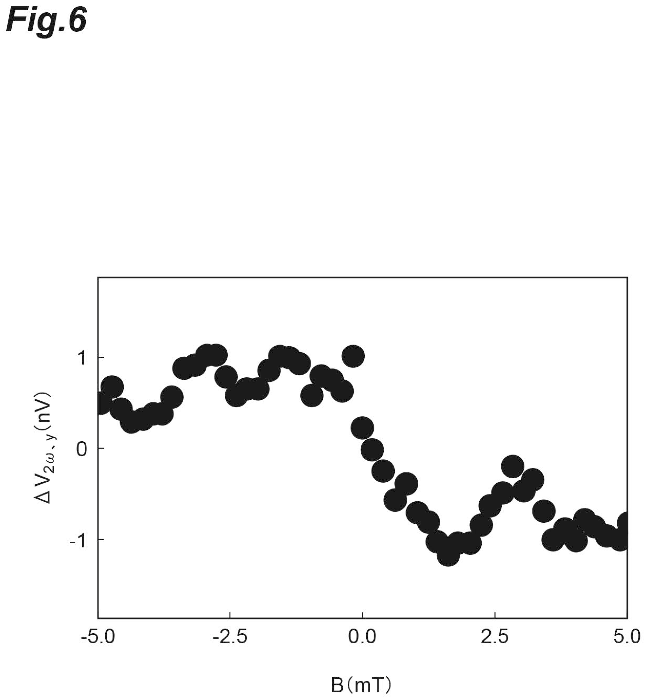

FIG. 6 is a diagram showing the dependence of a thermoelectric signal ΔV_{2ω}, _{y} obtained as a result of the above experiment on the external magnetic field B. Since ΔT_{AC} applied to the thermoelectric conversion element 200 varies sinusoidally, a temperature gradient is not virtually applied to the thermoelectric conversion element 200 on a macroscale, and ΔT_{AC} corresponds to temperature fluctuations on a microscale. If the thermoelectric signal output from the thermoelectric conversion element 200 is linear with respect to the polarity of the AC temperature gradient ΔT_{AC}, the thermoelectric signal ΔV_{2ω}, _{y} corresponding to twice the frequency of the AC temperature gradient ΔT_{AC} becomes zero because the thermoelectric signals corresponding to the positive and negative phases of the AC temperature gradient ΔT_{AC} cancel each other out. On the other hand, when the thermoelectric signal output from the thermoelectric conversion element 200 is nonlinear (non-reciprocal) with respect to the polarity of the AC temperature gradient ΔT_{AC}, the thermoelectric signal ΔV_{2ω}, _{y} has a finite value.

In this experiment, as shown in FIG. 6, a finite value of ΔV_{2ω}, _{y} was detected when the external magnetic field B was applied, and when the polarity of the external magnetic field B was reversed, the polarity of ΔV_{2ω}, _{y} was also reversed. Thereby, the thermoelectric conversion element used in this experiment can generate thermoelectric signals nonlinearly with respect to the direction of the temperature gradient, and thus this shows that thermoelectric conversion can be performed from temperature fluctuations on a microscale, where there is virtually no temperature gradient on a macroscale.

The present invention is not limited to the first embodiment described above, and various modifications can be made.

For example, in the first embodiment described above, the thermoelectric conversion element 200 includes the substrate 201 (see FIGS. 1 and 2), but the thermoelectric conversion element 200 may not include the substrate 201. In this case, the thermoelectric conversion layer 202 can be formed as a freestanding layer.

In the first embodiment described above, in step S13, the external magnetic field B is applied to the ferromagnetic metal layer 203 in the in-plane (in the XY plane) direction of the thermoelectric conversion element 200 and orthogonal to the direction of the flow of the heat flux H (see FIGS. 1 and 2), but it may be applied in a direction that is in the in-plane (in the XY plane) direction of the thermoelectric conversion element 200 and intersects the direction of the flow of the heat flux H at an angle other than 90 degrees. However, the external magnetic field B and the heat flux H are set such that they are not parallel or antiparallel to each other.

In the first embodiment described above, thermoelectric conversion is performed while applying the external magnetic field B in step S13 (see FIGS. 1 and 2), but if the ferromagnetic metal layer 203 has the magnetization 203M even without applying the external magnetic field B, thermoelectric conversion can be performed without applying the external magnetic field B in step S13. Examples of a method of achieving this include configuring the ferromagnetic metal layer 203 with a material having a large coercive force so that the ferromagnetic metal layer 203 has the magnetization 203M as a residual magnetization, and providing the thermoelectric conversion element 200 with a layer or member that applies a static or exchange coupling magnetic field to the ferromagnetic metal layer 203. For example, the thermoelectric conversion element 200 may further include antiferromagnetic layers such as NiO, IrMn, FeMn, NiMn, PtMn, PdMn, Mn2Au, FeRh, and MnSb, which are stacked on the side opposite to the paramagnetic metal layer 205 of the ferromagnetic metal layer 203 so as to apply an exchange coupling magnetic field to the ferromagnetic metal layer 203. Thereby, thermoelectric conversion can be performed without applying the external magnetic field B.

In the first embodiment described above, the pair of electrodes 207a and 207b are provided on the surface 205S of the paramagnetic metal layer 205 so that they are not in contact with the ferromagnetic metal layer 203 and are spaced apart from each other in the X-axis direction (see FIGS. 1 and 2). However, the pair of electrodes 207a and 207b may be provided on the side surfaces of the paramagnetic metal layer 205 in the positive and negative X-axis directions, respectively, so that they are not in contact with the ferromagnetic metal layer 203 and are spaced apart from each other in the X-axis direction.

Although the ferromagnetic metal layer 203 is a single layer in the first embodiment described above (see FIGS. 1 and 2), the ferromagnetic metal layer 203 may be composed of a plurality of stacked layers made of ferromagnetic metals. In this case, each of the plurality of layers is preferably made of a Ni-Fe alloy, Fe, Co, Ni, Gd, a CoFeB alloy, or a (Ga,Fe)Sb alloy. Such a plurality of stacked layers made of ferromagnetic metals may be, for example, a stacked body in which layers made of a plurality of types of ferromagnetic metals are periodically stacked on each other (for example, when a layer made of a first ferromagnetic metal is a layer A, a layer made of a second ferromagnetic metal is a layer B, and a layer made of a third ferromagnetic metal is a layer C, a stacked body is configured such that three types of layers are periodically stacked in the order of the layer A, the layer B, the layer C, the layer A, the layer B, the layer C, ...), or a stacked body in which layers made of a plurality of types of ferromagnetic metals are randomly stacked on each other (for example, a stacked body is configured such that three types of layers are randomly stacked in the order of the layer A, the layer B, the layer C, the layer B, the layer A, the layer C, ...).

Although the paramagnetic metal layer 205 is a single layer in the first embodiment described above (see FIGS. 1 and 2), the paramagnetic metal layer 205 may be composed of a plurality of stacked layers of paramagnetic metals. In this case, it is preferable that each of the plurality of layers be made of Pt, Pd, W, an AuW alloy, Ta, a CuIr alloy, a CuBi alloy, a BiSb alloy, or a BiSe alloy. Such a plurality of stacked layers of paramagnetic metals may be, for example, a stacked body in which layers configured with a plurality of types of paramagnetic metals are periodically stacked on each other (for example, when a layer made of a first paramagnetic metal is a layer D, a layer made of a second paramagnetic metal is a layer E, and a layer made of a third paramagnetic metal is a layer F, a stacked body is configured such that three types of layers are periodically stacked in the order of the layer D, the layer E, the layer F, the layer D, the layer E, the layer F, ...), or a stacked body in which layers configured with a plurality of types of paramagnetic metals are randomly stacked on each other (for example, a stacked body is configured such that three types of layers are randomly stacked in the order of the layer D, the layer E, the layer F, the layer E, the layer D, the layer F, ...). It is preferable that the plurality of stacked layers of paramagnetic metals described above have spin Nernst angles of the same sign. This is because non-reciprocal thermoelectric signals due to each of the plurality of layers of paramagnetic metals do not cancel each other out during thermoelectric conversion in the thermoelectric conversion layer 202, thereby increasing the magnitude of non-reciprocal thermoelectric signals as a whole.

In the first embodiment described above, the thermoelectric conversion layer 202 includes only one paramagnetic metal layer (paramagnetic metal layer 205) (see FIGS. 1 and 2), but the thermoelectric conversion layer 202 may include a first paramagnetic metal layer and a second paramagnetic metal layer. In this case, the thermoelectric conversion layer 202 is formed by stacking the first paramagnetic metal layer, the ferromagnetic metal layer 203, and the second paramagnetic metal layer in this order along the Z-axis direction so that the ferromagnetic metal layer 203 is interposed between the first paramagnetic metal layer and the second paramagnetic metal layer. Preferred constituent materials of the first and second paramagnetic metal layers are the same as that of the paramagnetic metal layer 205, and the configurations (constituent materials, thicknesses, and the like) of the first and second paramagnetic metal layers are selected such that the thermoelectric conversion layer 202 has a structure with broken spatial inversion symmetry in the Z-axis direction.

In this case, it is preferable that the first and second paramagnetic metal layers have spin Nernst angles of opposite signs. (For example, this can be achieved by forming the first paramagnetic metal layer of Pt and forming the second paramagnetic metal layer of Ta.) This is because, during thermoelectric conversion in the thermoelectric conversion layer 202, spin currents with the same directional polarity are injected into the ferromagnetic metal layer 203 from each of the first and second paramagnetic metal layers, thereby increasing the magnitude of the non-reciprocal thermoelectric signal.

Furthermore, in this case, each or either of the first and second paramagnetic metal layers may be composed of a plurality of paramagnetic metal layers stacked as described above. In this case, it is preferable that the plurality of paramagnetic metal layers constituting each or either of the first and second paramagnetic metal layers have spin Nernst angles of the same sign for the reasons mentioned above.

In the first embodiment described above, the pair of electrodes 207a and 207b are provided on the surface 205S of the paramagnetic metal layer 205 (see FIGS. 1 and 2), but the pair of electrodes 207a and 207b may be provided on the back surface (the surface on the negative Z-axis side) of the ferromagnetic metal layer 203 so that they are not in contact with the paramagnetic metal layer 205 and are spaced apart from each other in the X-axis direction.

In the first embodiment described above, the ferromagnetic metal layer 203 and the paramagnetic metal layer 205 are stacked in this order on the substrate 201 to configure the thermoelectric conversion layer 202 (see FIGS. 1 and 2), but the thermoelectric conversion layer 202 may be configured by stacking the paramagnetic metal layer 205 and the ferromagnetic metal layer 203 in this order on the substrate 201. In this case, the pair of electrodes 207a and 207b can be provided on the surface (the surface on the positive Z-axis side) of the ferromagnetic metal layer 203 or the back surface (the surface on the negative Z-axis side) of the paramagnetic metal layer 205 so that they are spaced apart from each other in the X-axis direction.

The thermoelectric conversion element, the thermoelectric conversion module, and the thermoelectric conversion method of the present disclosure have the following configurations.
[1] A thermoelectric conversion element including:
   a thermoelectric conversion part that has a nonlinear thermoelectric response characteristic for an input of a heat flux along a first direction; and
   an electrode part for extracting a thermoelectric signal generated in the thermoelectric conversion part due to the heat flux input to the thermoelectric conversion part from the outside along the first direction.
[2] The thermoelectric conversion element according to [1], in which
   the thermoelectric conversion part exhibits non-reciprocal conduction based on breaking of spatial inversion symmetry, and
   the electrode part includes a pair of electrodes for extracting non-reciprocal thermoelectric signals, the pair of electrodes being provided in the thermoelectric conversion part so as to be spaced apart from each other.
[3] The thermoelectric conversion element according to [2], in which
   the thermoelectric conversion part is a thermoelectric conversion layer including a ferromagnetic metal layer and a paramagnetic metal layer stacked on each other along a second direction orthogonal to the first direction, and
   the pair of electrodes are provided in the thermoelectric conversion layer so as to be spaced apart from each other along the first direction in an in-plane direction of the thermoelectric conversion layer.
[4] The thermoelectric conversion element according to [2] or [3], in which
   a separation distance between the pair of electrodes is 0.1 µm or more and 1000 µm or less.
[5] The thermoelectric conversion element according to [3] or [4], in which the paramagnetic metal layer includes a single layer or a plurality of stacked layers, and the single layer or each of the plurality of stacked layers of the paramagnetic metal layer is made of Pt, Pd, W, an AuW alloy, Ta, a CuIr alloy, a CuBi alloy, a BiSb alloy, or a BiSe alloy.
[6] The thermoelectric conversion element according to any one of [3] to [5], in which the ferromagnetic metal layer includes a single layer or a plurality of stacked layers, and the single layer or each of the plurality of stacked layers of the ferromagnetic metal layer is made of a Ni-Fe alloy, Fe, Co, Ni, Gd, a CoFeB alloy, or a (Ga,Fe)Sb alloy.
[7] A thermoelectric conversion module including a plurality of the thermoelectric conversion elements according to any one of [1] to [6], in which the plurality of thermoelectric conversion elements are electrically connected to each other so that thermoelectric signals from the thermoelectric conversion elements are superimposed on each other with the same polarity.
[8] A thermoelectric conversion method including:
   a step of preparing a thermoelectric conversion element including a thermoelectric conversion layer that exhibits non-reciprocal conduction based on breaking of spatial inversion symmetry, and a pair of electrodes provided in the thermoelectric conversion layer so as to be spaced apart from each other to extract non-reciprocal thermoelectric signals, the thermoelectric conversion layer including a ferromagnetic metal layer and a paramagnetic metal layer stacked on each other, and the pair of electrodes being provided in the thermoelectric conversion layer so as to be spaced apart from each other in an in-plane direction of the thermoelectric conversion layer; and
   a step of performing thermoelectric conversion while applying a magnetic field of 1 T or less to the ferromagnetic metal layer of the thermoelectric conversion layer.
[9] A thermoelectric conversion element including:
   a thermoelectric conversion layer that exhibits non-reciprocal conduction based on breaking of spatial inversion symmetry; and
   a pair of electrodes that are provided in the thermoelectric conversion layer so as to be spaced apart from each other to extract non-reciprocal thermoelectric signals, in which
   the thermoelectric conversion layer includes a paramagnetic metal layer and a ferromagnetic metal layer stacked on each other, and
   the pair of electrodes are provided in the paramagnetic metal layer so as to be spaced apart from each other in an in-plane direction of the paramagnetic metal layer (except for thermoelectric conversion elements provided with a layer made of an electrically insulating magnetic material in contact with a ferromagnetic metal layer).
[10] A thermoelectric conversion method including:
   a step of applying a temperature gradient including an AC component to a thermoelectric conversion part that exhibits non-reciprocal conduction based on breaking of spatial inversion symmetry; and
   a step of generating, by the thermoelectric conversion part, a non-reciprocal thermoelectric signal by thermoelectrically converting the temperature gradient including the AC component, based on the non-reciprocal conduction based on the breaking of spatial inversion symmetry.
[11] A thermoelectric conversion method using a thermoelectric conversion part including a first layer and a second layer, including:
   a step of applying a temperature gradient including an AC component to the thermoelectric conversion part; and
   a step of generating, by the first layer, a non-reciprocal thermoelectric signal by thermoelectrically converting the temperature gradient including the AC component, based on the fact that electron scattering of a flowing spin current depends on the direction of polarity of the spin current.
[12] A thermoelectric conversion element including:
   a thermoelectric conversion part;
   a first heat conduction part that is provided at one end of the thermoelectric conversion part in a first direction;
   a second heat conduction part that is provided at the other end of the thermoelectric conversion part in the first direction; and
   a pair of electrodes that are provided in the thermoelectric conversion part so as to be spaced apart from each other in the first direction,
   in which, when a temperature gradient including an AC component is applied between the first heat conduction part and the second heat conduction part, a DC electrical signal is generated in the thermoelectric conversion part, and the DC electrical signal can be extracted by the pair of electrodes.
[13] A thermoelectric conversion module including at least a first thermoelectric conversion element and a second thermoelectric conversion element, in which
   the first thermoelectric conversion element and the second thermoelectric conversion element each include a thermoelectric conversion part and a pair of electrodes provided in the thermoelectric conversion part so as to be spaced apart from each other to extract non-reciprocal thermoelectric signals, and
   one of the pair of electrodes of the first thermoelectric conversion element and one of the pair of electrodes of the second thermoelectric conversion element are electrically connected to each other so that the non-reciprocal thermoelectric signal from the first thermoelectric conversion element and the non-reciprocal thermoelectric signal from the second thermoelectric conversion element are able to be superimposed on each other with the same polarity.
[14] A thermoelectric conversion module including at least a first thermoelectric conversion element and a second thermoelectric conversion element, the thermoelectric conversion module including:
   a first heat conduction part that is provided at one ends of the first and second thermoelectric conversion elements in a first direction; and
   a second heat conduction part that is provided at the other ends of the first and second thermoelectric conversion elements in the first direction.
[15] The thermoelectric conversion module according to [13] or [14], for converting an applied temperature gradient including an AC component into a DC electrical signal.
[16] A thermoelectric conversion module including at least a first thermoelectric conversion element and a second thermoelectric conversion element, in which
   the first thermoelectric conversion element and the second thermoelectric conversion element each include a thermoelectric conversion part and a pair of electrodes provided in the thermoelectric conversion part so as to be spaced apart from each other to extract non-reciprocal thermoelectric signals, and
   a surface on which one of the pair of electrodes of the first thermoelectric conversion element is provided and a surface on which one of the pair of electrodes of the second thermoelectric conversion element is provided overlap each other in a region including edges of the first thermoelectric conversion element and the second thermoelectric conversion element, so that the one of the pair of electrodes of the first thermoelectric conversion element and the one of the pair of electrodes of the second thermoelectric conversion element are electrically connected to each other.

### (Second Embodiment)

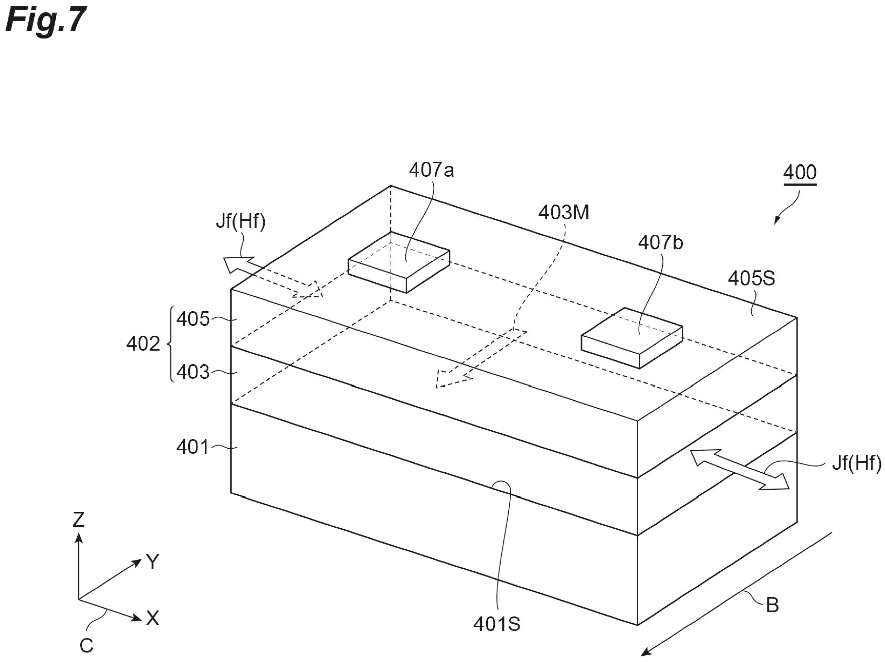

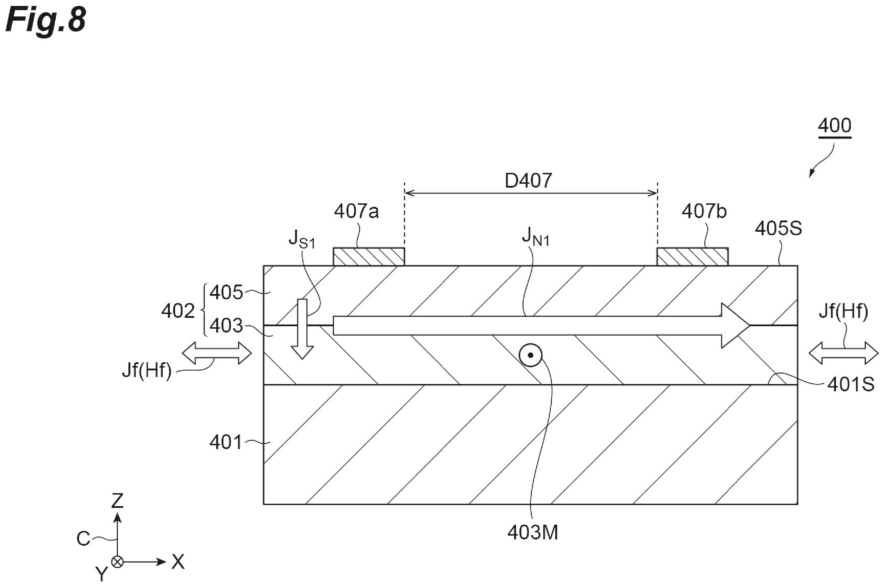

FIG. 7 is a perspective view showing a fluctuation detection sensor according to a second embodiment, and FIG. 8 is a cross-sectional view of the fluctuation detection sensor according to the second embodiment.

As shown in FIGS. 7 and 8, a fluctuation detection sensor 400 according to this embodiment includes a substrate 401, a nonlinear response layer 402 as a nonlinear response part, and a pair of electrodes 407a and 407b as electrode parts.

The substrate 401 is a plate-like or film-like member, for example, as shown in FIG. 7, and has a substantially flat surface 401S. The surface 401S has, for example, a rectangular shape when viewed from a Z-axis direction as shown in FIG. 7. The substrate 401 is a member for stacking the nonlinear response layer 402 on the surface 401S. Examples of the material configuring the substrate 401 include metals such as Au, Ag, Cu, and Al, silicon, sapphire, SiC, GaN, yttria stabilized zirconia (YSZ), and resins such as polyimide, polyethylene terephthalate (PET), and polyethylene naphthalate (PEN).

FIGS. 7 and 8 show an orthogonal coordinate system C in which a Z-axis is set in the thickness direction of the substrate 401, and an X-axis and a Y-axis are set in the long side and short side directions, respectively, of the rectangle of the surface 401S of the substrate 401. Also in the subsequent drawings, the orthogonal coordinate system C is shown where necessary.

The nonlinear response layer 402 has a nonlinear electrical response characteristic for an input of external energy along the X-axis direction which is a first direction. The external energy is, for example, an electric current and/or a heat flux. In this embodiment, the nonlinear response layer 402 includes a ferromagnetic layer 403 and a paramagnetic layer 405 stacked on each other along the Z-axis direction which is a second direction, the ferromagnetic layer 403 is stacked on the substrate 401, and the paramagnetic layer 405 is stacked on the ferromagnetic layer 403. The ferromagnetic layer 403 is made of a material that exhibits ferromagnetism at temperatures in the use environment of the fluctuation detection sensor 400, and is preferably made of a material that exhibits ferromagnetism at room temperature (300 K). In this embodiment, the ferromagnetic layer 403 may be made of a hard magnetic material and may have a spontaneous magnetization 403M. It is preferable that the ferromagnetic layer 403 have a high coercive force, for example, 50 mT or more.

The ferromagnetic layer 403 is preferably a ferromagnetic metal layer. It is preferable that the ferromagnetic metal layer be made of an L1₀ type ordered alloy composed of a magnetic metal that exhibits ferromagnetism at room temperature (300 K) and a paramagnetic metal that exhibits paramagnetism. It is preferable that the magnetic metal be made of at least one of, for example, iron, nickel, cobalt, gadolinium, dysprosium, or terbium, and the paramagnetic metal be made of, for example, Pt, Pd, W, an AuW alloy, Ta, a CuIr alloy, a CuBi alloy, a BiSb alloy, or a BiSe alloy. Because the ferromagnetic layer 403 is made of such an L1₀ type ordered alloy, the ferromagnetic layer 403 can have a particularly large coercive force, and thus energy conversion of a current fluctuation and/or a heat flux fluctuation by the fluctuation detection sensor 400, as described below, can be efficiently performed under room-temperature and zero-magnetic-field conditions.

The nonlinear response layer 402 has, for example, a rectangular shape in plan view (that is, viewed from the Z-axis direction) with a long side in the X-axis direction and a short side in the Y-axis direction. The thickness of the ferromagnetic layer 403 is not particularly limited, but may be, for example, 1 nm or more and 100 nm or less.

The paramagnetic layer 405 is made of a material that exhibits paramagnetism at temperatures in the use environment of the fluctuation detection sensor 400, and is preferably made of a material that exhibits paramagnetism at room temperature (300 K). The paramagnetic layer 405 is preferably a paramagnetic metal layer. It is preferable that the paramagnetic metal layer be made of a paramagnetic metal with a high spin-orbit interaction to increase the spin Nernst effect and the spin Hall effect inside the paramagnetic metal layer as described below. From this viewpoint, the paramagnetic metal layer is preferably made of Pt, Pd, W, an AuW alloy, Ta, a CuIr alloy, a CuBi alloy, a BiSb alloy, or a BiSe alloy, and particularly preferably made of Pt. The thickness of the paramagnetic layer 405 is not particularly limited, but may be, for example, 1 nm or more and 100 nm or less.

In this embodiment, the nonlinear response layer 402 exhibits non-reciprocal conduction based on the breaking of spatial inversion symmetry. Specifically, a paramagnetic layer is provided on the surface of the ferromagnetic layer 403, but no similar paramagnetic layer is provided on the back surface of the ferromagnetic layer 403. A ferromagnetic layer is provided on the back surface of the paramagnetic layer 405, but no similar ferromagnetic layer is provided on the surface of the paramagnetic layer 405. For this reason, the nonlinear response layer 402 has a structure in which spatial inversion symmetry is broken in the Z-axis direction. The nonlinear response layer 402 has substantial spatial inversion symmetry in a direction along an XY plane. The nonlinear response layer 402 in this embodiment exhibits irreciprocity with respect to electrical conductivity in the in-plane (in the XY plane) direction due to the breaking of spatial inversion symmetry in the Z-axis direction.

The pair of electrodes 407a and 407b are provided in the nonlinear response layer 402 so as to be spaced apart from each other in the in-plane (in the XY plane) direction of the nonlinear response layer 402. In this embodiment, the pair of electrodes 407a and 407b are provided in the paramagnetic layer 405 so as not to be in contact with the ferromagnetic layer 403 and are provided on the surface 405S on the side opposite to the ferromagnetic layer 403 of the paramagnetic layer 405. The pair of electrodes 407a and 407b are spaced apart from each other in the X-axis direction, which is one of the in-plane (in the XY plane) directions of the paramagnetic layer 405.

The pair of electrodes 407a and 407b are made of a material having a conductivity capable of extracting a non-reciprocal voltage signal from the nonlinear response layer 402 as described below. Examples of such a material include metal materials, such as Cu, Ag, Au, Pt, Ni, Al, constantan, Cr, In, Pd, Fe, a Cu alloy, a Ti/Au laminate, and a Cr/Au laminate, and conductive oxides such as indium tin oxide (ITO) and zinc oxide (ZnO). Cu, Ag, Au, Pt, Ni, Al, constantan, and a Cu alloy are preferable, and Cu, Au, Ag, Pt, Ni, a Ti/Au laminate, and a Cr/Au laminate are particularly preferable.

The thicknesses of the pair of electrodes 407a and 407b are not particularly limited, but may be, for example, 10 nm or more and 1 µm or less. A separation distance D407 between the pair of electrodes 407a and 407b in the X-axis direction is preferably 0.1 µm or more and 1000 µm or less.

The fluctuation detection sensor 400 of this embodiment may or may not further include a layer made of an electrically insulating magnetic material and provided in contact with the ferromagnetic layer 403.

When manufacturing such a fluctuation detection sensor 400, for example, the substrate 401 is prepared, and a material for configuring the ferromagnetic layer 403 and a material for configuring the paramagnetic layer 405 are deposited in this order on the surface 401S thereof by a physical vapor deposition method such as a DC magnetron sputtering method to form a stacked body, and the nonlinear response layer 402 is formed by patterning the stacked body into a rectangular shape in plan view by a photolithography method and a lift-off method. Thereafter, the metal materials for configuring the pair of electrodes 407a and 407b are deposited in a region including the surface 405S of the paramagnetic layer 405 by a physical vapor deposition method such as a DC magnetron sputtering method to form a metal layer, and the metal layer is patterned into a predetermined shape by a photolithography method and a lift-off method so as to form the pair of electrodes 407a and 407b.

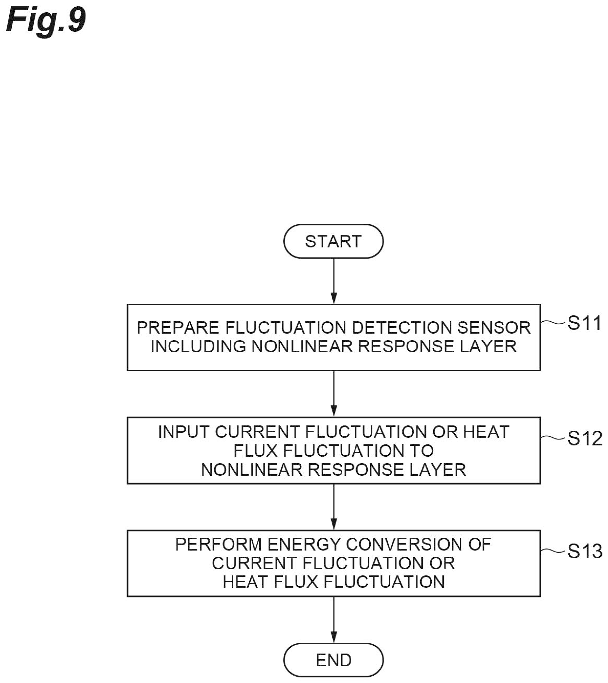

Next, an energy conversion method according to this embodiment will be described. FIG. 9 is a flowchart showing steps of the energy conversion method according to this embodiment. As shown in FIG. 9, the energy conversion method according to this embodiment includes step S11 of preparing a fluctuation detection sensor including a nonlinear response layer, step S12 of inputting a current fluctuation or a heat flux fluctuation to the nonlinear response layer, and step S13 of performing energy conversion of the current fluctuation or the heat flux fluctuation. These steps will be described with reference to FIGS. 7 and 8 again.

In step S11 of preparing the fluctuation detection sensor including the nonlinear response layer, the fluctuation detection sensor 400 described above is prepared as shown in FIGS. 7 and 8. Next, in step S12 of inputting the current fluctuation or the heat flux fluctuation to the nonlinear response layer, in a state where the ferromagnetic layer 403 has spontaneous magnetization 403M, an external current fluctuation Jf or heat flux fluctuation Hf, which is subjected to energy conversion, is input to the nonlinear response layer 402 so that it flows in the X-axis direction, which is one of the in-plane (in the XY plane) directions of the nonlinear response layer 402.

In this specification, the "current fluctuation" refers to a phenomenon in which a current fluctuates temporally and spatially, specifically, a situation in which a current in a certain direction (for example, the X-axis direction) and a current in the opposite direction (for example, the -X-axis direction) overlap each other and the direction of a net current fluctuates temporally and spatially. The "heat flux fluctuation" refers to a phenomenon in which a heat flux fluctuates temporally and spatially, specifically, a situation in which a heat flux in a certain direction (for example, the X-axis direction) and a heat flux in the opposite direction (for example, the -X-axis direction) overlap each other and the direction of a net heat flux fluctuates temporally and spatially.

In step S12, when the current fluctuation Jf is input to the paramagnetic layer 405, a spin current J_{S1} is generated in the Z-axis direction by a spin Hall effect, and when the heat flux fluctuation Hf is input to the paramagnetic layer 405, a spin current J_{S1} is generated in the Z-axis direction by a spin Nernst effect.

In step S13 of performing the energy conversion of the current or heat flux fluctuation, the spin current J_{S1} generated as described above flows into the ferromagnetic layer 403 having the spontaneous magnetization 403M. The polarity of the spin current J_{S1} changes in the positive Y-axis direction or the negative Y-axis direction in accordance with the direction of a current due to the current fluctuation Jf (that is, the direction of a net current of the current fluctuation Jf at a certain point in time and a certain location) or the direction of a heat flux due to the heat flux fluctuation Hf (that is, the direction of a net heat flux of the heat flux fluctuation Hf at a certain point in time and at a certain location). Therefore, when the direction of the above-mentioned current or heat flux is reversed, the polarity of the spin current J_{S1} is reversed, and the relative direction relationship between the polarity of the spin current J_{S1} and the direction of the spontaneous magnetization 403M of the ferromagnetic layer 403 is reversed. By reversing the direction of the spontaneous magnetization 403M of the ferromagnetic layer 403, the relative direction relationship between the polarity of the spin current J_{S1} and the direction of the spontaneous magnetization 403M can also be reversed.

When the spin current J_{S1} flows into the ferromagnetic layer 403, the mode of electron scattering changes depending on the relative direction of the polarity direction of the spin current J_{S1} and the direction of the spontaneous magnetization 403M of the ferromagnetic layer 403. Since the polarity direction of the spin current J_{S1} near a junction interface between the ferromagnetic layer 403 and the paramagnetic layer 405 changes depending on the direction of the above-mentioned current or heat flux, the mode of this electron scattering changes depending on the direction of the above-mentioned current or heat flux. Thereby, the electrical response signal generated in the nonlinear response layer 402 has dependence on the direction of the above-mentioned current or heat flux, that is, irreciprocity.

The inventors of the present application have found that a voltage conversion signal J_{N1}, which serves as an electrical response signal generated in the nonlinear response layer 402 in this manner, is non-reciprocal with respect to the direction of the above-mentioned current or heat flux due to the non-reciprocal conduction of the nonlinear response layer 402 as described above (that is, the voltage conversion signal J_{N1} changes in proportion to the quadratic of the current fluctuation Jf or heat flux fluctuation Hf), that the direction of the voltage conversion signal J_{N1} is the positive X-axis direction regardless of whether the direction of the above-mentioned current or heat flux is the positive X-axis direction or the negative X-axis direction, and that such a non-reciprocal voltage conversion signal J_{N1} can be electrically extracted via the pair of electrodes 407a and 407b. For this reason, according to the fluctuation detection sensor 400 of this embodiment, even when the direction and magnitude of the above-mentioned current due to the current fluctuation Jf or the above-mentioned heat flux due to the heat flux fluctuation Hf change randomly, a non-reciprocal voltage signal J_{N1} can be generated in a constant direction within the nonlinear response layer 402, and thus it becomes possible to detect an energy fluctuation can be detected from the current fluctuation Jf or the heat flux fluctuation Hf on a microscale.

When the current fluctuation Jf is input to the nonlinear response layer 402, in the nonlinear response layer 402, when the magnitude of the voltage of the non-reciprocal voltage signal J_{N1} extracted by the pair of electrodes 407a and 407b is V, the electric field generated in the nonlinear response layer 402 corresponding to V is E, a distance between the pair of electrodes 407a and 407b is L (D407 in FIG. 8), and a current density within the distance L of the nonlinear response layer 402 is j, the relation of Electric field E = Nonlinear electrical transport coefficient γ × Electrical resistivity ρ × (current density j)² is established. By multiplying both sides of this formula by the distance L, the relation of Voltage V = L x γ x ρ x j² is established, and thus the larger the distance L between the pair of electrodes 407a and 407b, the larger the voltage V. For this reason, by setting the separation distance D407 in the X-axis direction between the pair of electrodes 407a and 407b to a large value, preferably 1000 µm or more, as described above, the non-reciprocal voltage signal J_{N1} extracted by the pair of electrodes 407a and 407b becomes larger.

Similarly, when the heat flux fluctuation Hf is input to the nonlinear response layer 402, in the nonlinear response layer 402, when the magnitude of the voltage of the non-reciprocal voltage signal J_{N1} extracted by the pair of electrodes 407a and 407b is V, the electric field generated in the nonlinear response layer 402 corresponding to V is E, the nonlinear Seebeck coefficient of the nonlinear response layer 402 is S, a distance between the pair of electrodes 407a and 407b is L (D407 in FIG. 8), a temperature gradient in the range of the distance L of the nonlinear response layer 402 is VT, and a temperature difference in the range of the distance L of the nonlinear response layer 402 is ΔT, the relation of Electric field E = Nonlinear Seebeck coefficient S × (temperature gradient ∇T)² is established. By multiplying both sides of this formula by the distance L, the relation of Voltage V = Nonlinear Seebeck coefficient S x (temperature difference ΔT)²/L is established, and thus the smaller the distance L between the pair of electrodes 407a and 407b, the larger the voltage V. For this reason, by setting the separation distance D407 in the X-axis direction between the pair of electrodes 407a and 407b to a small value, preferably 1000 µm or less, as described above, the non-reciprocal voltage signal J_{N1} extracted by the pair of electrodes 407a and 407b becomes larger.

The fluctuation detection sensor 400 may also include a heat conduction part that is provided in contact with or in close proximity to an end face on the positive X-axis side and/or an end face on the negative X-axis side to facilitate the flowing of the current fluctuation Jf or the heat flux fluctuation Hf into the nonlinear response layer 402. Such a heat conduction part can be made of, for example, aluminum, copper, carbon fiber, sapphire, alumina, silicon with a thermal oxide film, or a polymeric polymer.

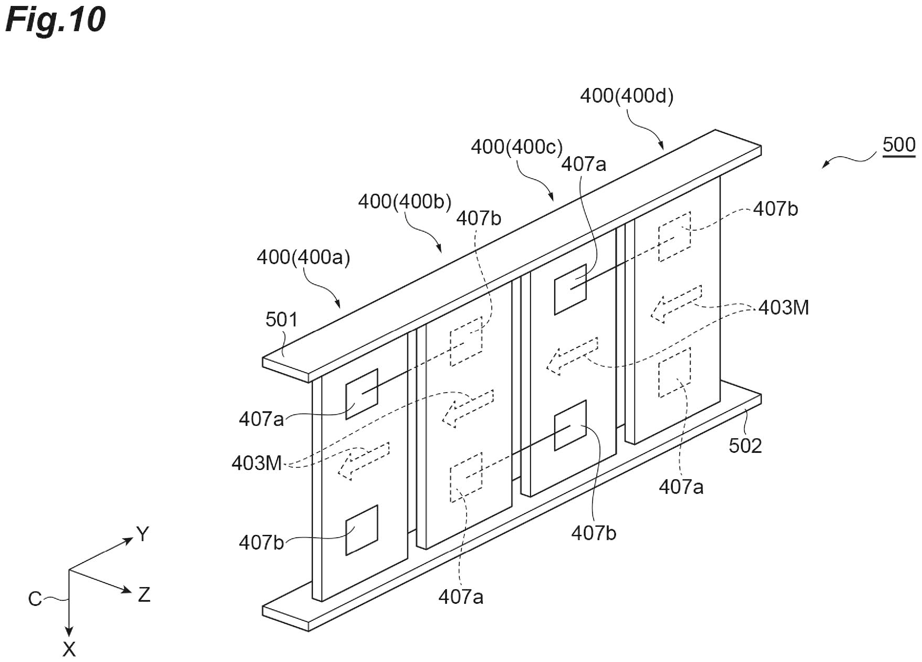

FIG. 10 is a perspective view showing the configuration of a fluctuation detection sensor module using the above-described fluctuation detection sensor. As shown in FIG. 10, a fluctuation detection sensor module 500 according to this embodiment includes a plurality of fluctuation detection sensors 400, and includes four fluctuation detection sensors 400a, 400b, 400c, and 400d in this embodiment. The four fluctuation detection sensors 400a, 400b, 400c, and 400d are electrically connected to each other so that non-reciprocal voltage signals J_{N1} from the respective nonlinear electron transport voltage conversion elements are superimposed on each other with the same polarity.

Specifically, in the fluctuation detection sensor module 500, the fluctuation detection sensors 400a and 400c, which are disposed with respect to the orthogonal coordinate system C in a manner similar to the fluctuation detection sensor 400 shown in FIGS. 7 and 8, and the fluctuation detection sensors 400b and 400d, which are disposed with respect to the orthogonal coordinate system C in a manner that rotates the fluctuation detection sensor 400 shown in FIGS. 7 and 8 by 180 degrees around the Y-axis, are provided alternately in the Y-axis direction. Then, the electrode 407a of the fluctuation detection sensor 400a and the electrode 407b of the fluctuation detection sensor 400b are electrically connected to each other, the electrode 407a of the fluctuation detection sensor 400b and the electrode 407b of the fluctuation detection sensor 400c are electrically connected to each other, and the electrode 407a of the fluctuation detection sensor 400c and the electrode 407b of the fluctuation detection sensor 400d are electrically connected to each other. Instead of disposing the fluctuation detection sensors 400b and 400d in a manner that they are rotated by 180 degrees around the Y-axis, the fluctuation detection sensors 400b and 400d may be disposed, like the fluctuation detection sensors 400a and 400c, in the same manner as the fluctuation detection sensor 400 shown in FIGS. 7 and 8 with respect to the orthogonal coordinate system C, and then the stacking order of the ferromagnetic layer 403 and the paramagnetic layer 405 of the nonlinear response layer 402 can be reversed in the fluctuation detection sensors 400b and 400d. **In** this case, the electrode 407a of the fluctuation detection sensor 400a and the electrode 407a of the fluctuation detection sensor 400b are electrically connected to each other, the electrode 407b of the fluctuation detection sensor 400b and the electrode 407b of the fluctuation detection sensor 400c are electrically connected to each other, and the electrode 407a of the fluctuation detection sensor 400c and the electrode 407a of the fluctuation detection sensor 400d are electrically connected to each other.

The fluctuation detection sensor module 500 also includes heat conduction parts 501 and 502 provided in contact with or in close proximity to the end faces on the negative X-axis and positive X-axis sides of the four fluctuation detection sensors 400a, 400b, 400c, and 400d. Thereby, a heat flux flowing in the X-axis direction easily flows into the respective ferromagnetic layers 403 of the four fluctuation detection sensors 400a, 400b, 400c, and 400d. The fluctuation detection sensor module 500 may not include the heat conduction parts 501 and 502.

Non-reciprocal voltage signals generated in the fluctuation detection sensors 400 by the current or heat flux fluctuation flowing into the respective ferromagnetic layers 403 of the four fluctuation detection sensors 400a, 400b, 400c, and 400d can be superimposed on each other with the same polarity and then extracted by the electrode 407b of the fluctuation detection sensor 400a and the electrode 407a of the fluctuation detection sensor 400d, thereby making it possible to extract large non-reciprocal voltage signals. The fluctuation detection sensor module 500 can also include more fluctuation detection sensors 400, and in this case, larger non-reciprocal voltage signals can be extracted.

### (Example 3: Input of Current Fluctuation)

Next, Examples 3 and 4 will be used to further clarify the effects of the invention according to the second embodiment. As Example 3, an element corresponding to the fluctuation detection sensor 400 was manufactured as follows so as to correspond to step S11 of preparing a fluctuation detection sensor including a nonlinear response layer. First, a (111)-oriented magnesium oxide substrate with a thickness of 0.5 mm was prepared as the substrate 401, and the ferromagnetic layer 403 was formed on the substrate by co-sputtering Co at DC 37 W and Pt at RF 109 W at 0.046 nm/s using DC and RF magnetron sputtering methods, thereby forming a CoPt alloy layer, which is an L1₀ type ordered alloy, to a thickness of 7.5 nm. Furthermore, a Pt layer with a thickness of 7.5 nm was deposited on this CoPt alloy layer as the paramagnetic layer 405 to form the nonlinear response layer 402. Then, the nonlinear response layer 402 was patterned by photolithography and lift-off methods into a Hall element shape in plan view, that is, a shape, in plan view, having a rectangular part with a width of 10 µm in the Y-axis direction and a length of 40 µm in the X-axis direction and two protrusions protruding in the Y-axis direction from both ends of the rectangular part. Then, a Ti/Au layer was deposited on the nonlinear response layer 402 by an RF magnetron sputtering method, and the Ti/Au layer was patterned into a predetermined shape by photolithography and lift-off methods to form a pair of electrodes corresponding to the pair of electrodes 407a and 407b in the protrusions and form a pair of electrodes 408a and 408b for an AC power supply 418 to be described below at both ends of the rectangular part in the X-axis direction, thereby manufacturing an element corresponding to the fluctuation detection sensor 400.

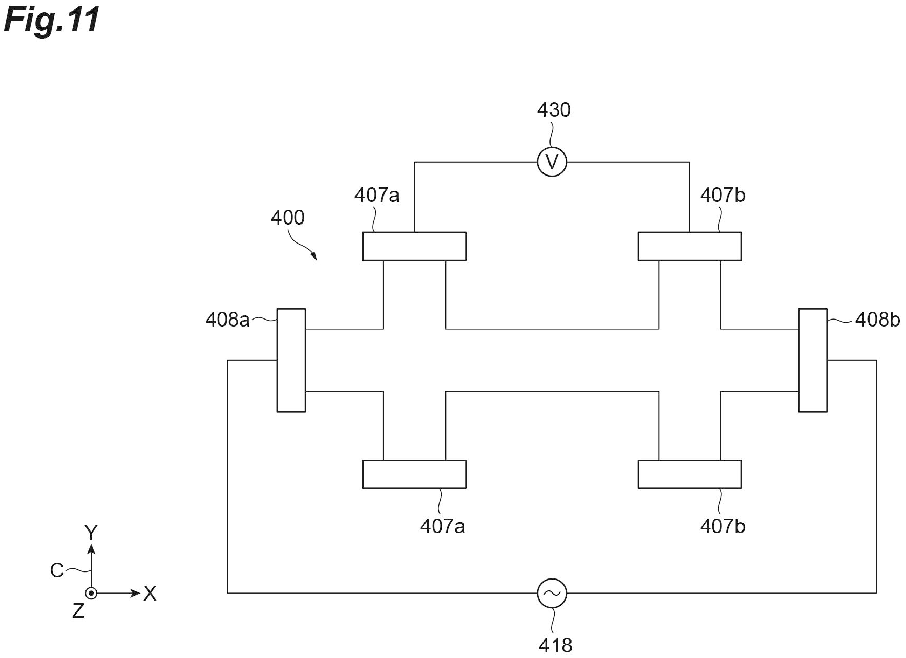

Next, the element manufactured in this manner was subjected to an experiment corresponding to step S12 of inputting a current or heat flux fluctuation to the nonlinear response layer, and step S13 of performing energy conversion of the current or heat flux fluctuation. Specifically, the element was subjected to an experiment of inputting a current fluctuation so as to correspond to step S12 and measuring a non-reciprocal voltage signal J_{N1} output from the pair of electrodes 407a and 407b at room temperature (300 K). FIG. 11 is a schematic diagram showing an experimental method of measuring a non-reciprocal voltage signal J_{N1}. As shown in FIG. 11, an AC power supply 418 was electrically connected between the pair of electrodes 408a and 408b provided in the fluctuation detection sensor 400. A lock-in amplifier 430 was electrically connected between the pair of electrodes 407a and 407b.

An AC current, which varies sinusoidally with an angular frequency ω, was applied in a direction along the X-axis while varying the magnitude of an external magnetic field B, which was applied to the fluctuation detection sensor in the negative Y-axis direction in Example 3, from 2 T to -2 T. Then, among voltage signals generated in the fluctuation detection sensor in Example 3, ΔV_{2ω, y}, which is a y component of a variation in a voltage signal corresponding to twice the frequency of the AC current, was detected by the lock-in amplifier 430.

More specifically, regarding the AC current, when ω represents an angular frequency and t represents a time, an AC current expressed as I_{AC} = (√2)Iᵣₘₛsin(ωt) was applied to the fluctuation detection sensor 400 in a direction along the X-axis by the AC power supply 418 (Iᵣₘₛ means an effective value of the AC current). Experiments were performed for cases where Iᵣₘₛ was 0.01 mA and a case where Iᵣₘₛ was 2.77 mA, respectively. A 6221 type AC/DC current source manufactured by Tektronix, Inc. in the United States was used as the AC power supply 418, and a lock-in amplifier LI5640 manufactured by NF Corporation was used as the lock-in amplifier 430. The frequency f (= ω / 2 π) of the AC voltage applied by the AC power supply 418 was set to 13.423 Hz. The lock-in conditions of the lock-in amplifier 430 were set to a time constant of 1 second and a slope of -24 dB.

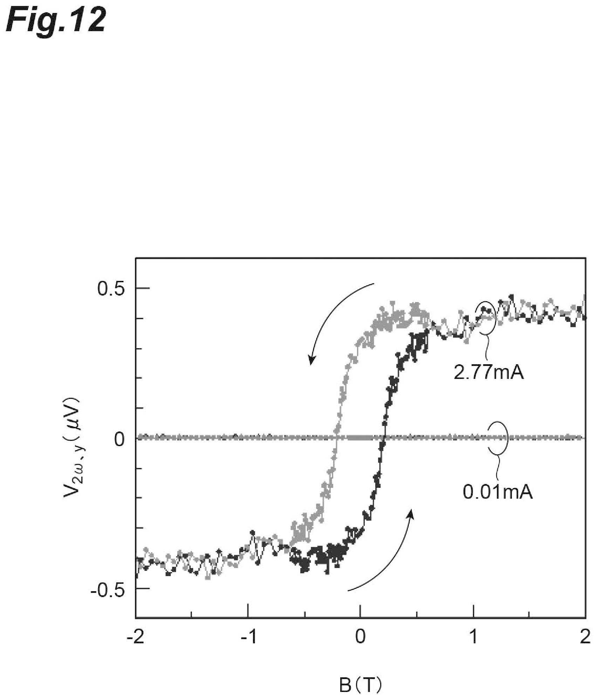

FIG. 12 is a diagram showing the dependence of a voltage signal ΔV_{2ω, y} obtained as a result of the above experiment in Example 3 on the external magnetic field B. Since the I_{AC} applied to the fluctuation detection sensor in Example 3 varies sinusoidally, a time average of a current flowing through the fluctuation detection sensor in Example 3 is zero (that is, < I_{AC} > = 0), and I_{AC} corresponds to a current fluctuation Jf on a microscale. If the voltage signal output from the fluctuation detection sensor in Example 3 is linear with respect to the polarity of the AC current I_{AC}, the voltage signal ΔV_{2ω, y} corresponding to twice the frequency of the AC current I_{AC} becomes zero because voltage signals corresponding to the positive and negative phases of the AC current I_{AC} cancel each other out. On the other hand, when the voltage signal output from the fluctuation detection sensor in Example 3 is nonlinear (non-reciprocal) with respect to the polarity of the AC current I_{AC}, the voltage signal ΔV_{2ω, y} has a finite value.

In this experiment, as shown in FIG. 12, when Iᵣₘₛ was 2.77 mA, a finite value of ΔV_{2ω, y} was detected when an external magnetic field B was applied, and when the polarity of the external magnetic field B was reversed, the polarity of ΔV_{2ω, y} was also reversed. As indicated by arrows in FIG. 12, it became apparent that the voltage signal ΔV_{2ω, y} has hysteresis with respect to the application of the external magnetic field B, and that the voltage signal ΔV_{2ω, y} indicates a significant value even when the external magnetic field B is zero. Thereby, the fluctuation detection sensor in Example 3 can generate a voltage signal non-reciprocally with respect to the direction of a current, and thus it is shown that, even when the time average of the current is zero, energy can be converted from the current fluctuation Jf into a non-reciprocal voltage signal even in a situation where no external magnetic field is applied.

### (Example 4: Input of Heat Flux Fluctuation)

Next, an experiment was performed for Example 4. As Example 4, an element corresponding to the fluctuation detection sensor 400 was manufactured as follows so as to correspond to step S11 of preparing a fluctuation detection sensor including a nonlinear response layer. First, a (111)-oriented magnesium oxide substrate with a thickness of 0.5 mm was prepared as the substrate 401, and on this substrate, a CoPt alloy layer, which is an L10 type ordered alloy with a thickness of 7.5 nm, was formed as the ferromagnetic layer 403 by co-sputtering Co at DC 37 W and Pt at RF 109 W at 0.046 nm/s using DC and RF magnetron sputtering methods. Furthermore, a Pt layer with a thickness of 5 nm was deposited on this CoPt alloy layer as the paramagnetic layer 405 to form the nonlinear response layer 402. Then, the nonlinear response layer 402 was patterned by photolithography and lift-off methods into a rectangular shape with a width of 7.5 µm in the Y-axis direction and a length of 60 µm in the X-axis direction. Then, a Ti/Au layer was deposited on the nonlinear response layer 402 by an RF magnetron sputtering method, and the Ti/Au layer was patterned into a predetermined shape by photolithography and lift-off methods to form a pair of electrodes corresponding to the pair of electrodes 407a and 407b, thereby manufacturing an element corresponding to the fluctuation detection sensor 400.

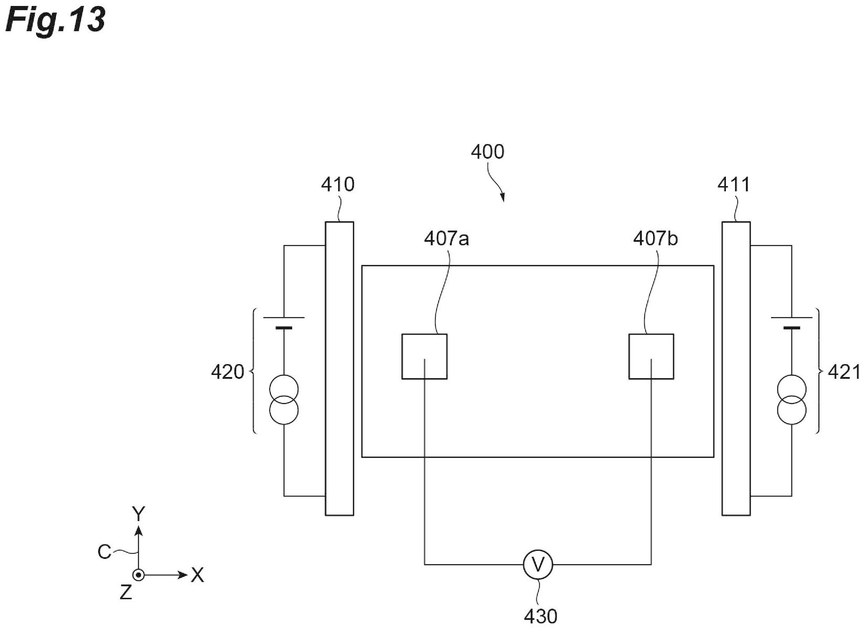

Next, the element manufactured in this manner was subjected to an experiment corresponding to step S12 of inputting a current or heat flux fluctuation to the nonlinear response layer, and step S13 of performing energy conversion of the current or heat flux fluctuation. Specifically, the element was subjected to an experiment of inputting a heat flux fluctuation Hf as step S12 and measuring non-reciprocal voltage signals J_{N1} output from the pair of electrodes 407a and 407b at room temperature (300 K). As shown in FIG. 13, a first resistor heater 410 was provided adjacent to the end of the element in the negative X-axis direction corresponding to the fluctuation detection sensor 400 in Example 4, and a second resistor heater 411 was provided adjacent to the end of the element in the positive X-axis direction. A first power supply 420 and a second power supply 421 were electrically connected to the first resistor heater 410 and the second resistor heater 411, respectively. A lock-in amplifier 430 was electrically connected between the pair of electrodes 407a and 407b.

Then, while varying the magnitude of the external magnetic field B applied to the fluctuation detection sensor in Example 4 in the negative Y-axis direction from 2 T to -2 T, an AC temperature gradient ΔT_{AC}, which varies sinusoidally with an angular frequency ω in a direction along the X-axis, was applied to the fluctuation detection sensor in Example 4 by the first resistor heater 410 and the second resistor heater 411. Then, among the thermoelectric signals generated by the fluctuation detection sensor in Example 4, ΔV_{2ω, y}, which is a y component of a variation in a thermoelectric signal corresponding to twice the frequency of the AC temperature gradient ΔT_{AC}, was detected by the lock-in amplifier 430.

More specifically, regarding the AC temperature gradient ΔT_{AC}, when ω represents an angular frequency and t represents a time, an AC voltage of V_{dc} + V_{ac} sin (ωt) was applied to the first resistor heater 410 by the first power supply 420, and an AC voltage of V_{dc} - V_{ac}sin (ωt), which is in the opposite phase thereto, was applied to the second resistor heater 411 by the second power supply 421. Thereby, an AC temperature gradient expressed as ΔT_{AC} = (√2)ΔTᵣₘₛsin(ωt) was applied to the fluctuation detection sensor 400 in the direction along the X-axis (ΔTᵣₘₛ is an effective value of the AC temperature gradient). A voltage source device WF1948 manufactured by NF Corporation was used as the first power supply 420 and the second power supply 421, and a lock-in amplifier LI5640 manufactured by NF Corporation was used as the lock-in amplifier 430. The frequency f (= ω / 2 π) of the AC voltage applied by the first power supply 420 and the second power supply 421 was set to 3.723 Hz. As the lock-in conditions for the lock-in amplifier 430, a time constant was set to 1 second, and a slope was set to -24 dB.

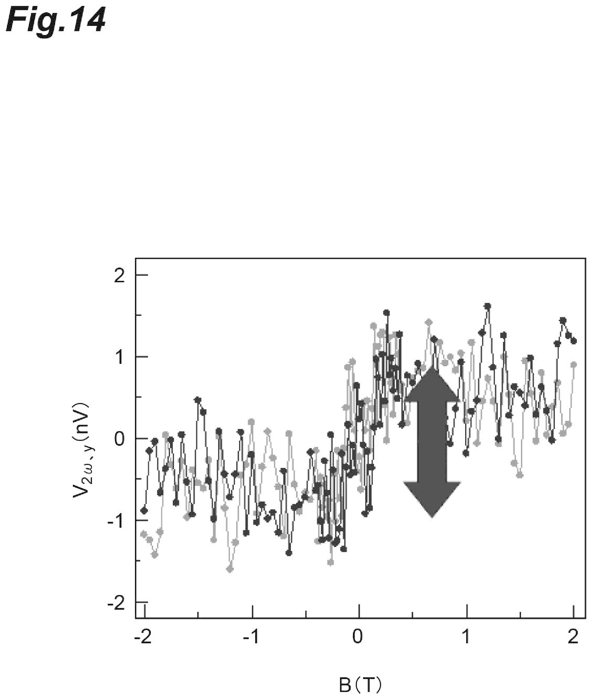

FIG. 14 is a diagram showing the dependence of a voltage signal ΔV_{2ω, y} obtained as a result of the above experiment in Example 4 on the external magnetic field B. Since ΔT_{AC} applied to the fluctuation detection sensor in Example 4 varies sinusoidally, a temperature gradient is virtually not applied to the fluctuation detection sensor in Example 4 on a macroscale, and ΔT_{AC} corresponds to temperature fluctuations on a microscale. If the voltage signal output from the fluctuation detection sensor in Example 4 is linear with respect to the polarity of the AC temperature gradient ΔT_{AC}, the voltage signal ΔV2ω corresponding to twice the frequency of the AC temperature gradient ΔT_{AC}, y becomes zero because the thermoelectric signals corresponding to the positive and reverse phases of the AC temperature gradient ΔT_{AC} cancel each other out. On the other hand, when the voltage signal output from the fluctuation detection sensor in Example 4 is nonlinear (non-reciprocal) with respect to the polarity of the AC temperature gradient ΔT_{AC}, the voltage signal ΔV_{2ω, y} has a finite value.

In this experiment, as shown in FIG. 14, a finite value of ΔV_{2ω, y} was detected when the external magnetic field B was applied, and when the polarity of the external magnetic field B was reversed, the polarity of ΔV_{2ω, y} was also reversed. It became apparent that the voltage signal ΔV_{2ω, y} indicates a significant value even when the external magnetic field B is zero. Thereby, the fluctuation detection sensor in Example 4 can generate a voltage signal non-reciprocally with respect to the direction of a temperature gradient, and thus it was shown that energy can be converted from the heat flux fluctuation Hf into a non-reciprocal voltage signal on a microscale, where there is virtually no temperature gradient on a macroscale.

The present invention is not limited to the second embodiment described above, and various modifications can be made.

For example, in the second embodiment described above, the fluctuation detection sensor 400 includes the substrate 401 (see FIGS. 7 and 8), but the fluctuation detection sensor 400 may not include the substrate 401. In this case, the nonlinear response layer 402 can be formed as a freestanding layer.

In the second embodiment described above, in step S12 of inputting a current or heat flux fluctuation to a nonlinear response layer, either the current fluctuation Jf or the heat flux fluctuation Hf was input to the nonlinear response layer 402 (see FIGS. 7 and 8), but both the current fluctuation Jf and the heat flux fluctuation Hf may be input to the nonlinear response layer 402 so as to be superimposed thereon.

In the second embodiment described above, step S12 of inputting a current fluctuation or a heat flux fluctuation to a nonlinear response layer and step S13 of performing energy conversion of the current fluctuation or the heat flux fluctuation are performed in a state where the ferromagnetic layer 403 has the spontaneous magnetization 403M, but these steps may be performed by forming the ferromagnetic layer 403 of a soft magnetic material and applying an external magnetic field to the ferromagnetic layer 403 to magnetize the ferromagnetic layer 403 to the same level as the spontaneous magnetization 403M.

In the second embodiment described above, the pair of electrodes 407a and 407b are provided on the surface 405S of the paramagnetic layer 405 so that they are not in contact with the ferromagnetic layer 403 and are spaced apart from each other in the X-axis direction (see FIGS. 7 and 8). However, the pair of electrodes 407a and 407b may be provided on the side surfaces of the paramagnetic layer 405 in the positive and negative X-axis directions, respectively, so that they are not in contact with the ferromagnetic layer 403 and are spaced apart from each other in the X-axis direction.

Although the paramagnetic layer 405 was a single layer in the second embodiment described above (see FIGS. 7 and 8), the paramagnetic layer 405 may be composed of a plurality of stacked paramagnetic metal layers. In this case, each of the plurality of layers is preferably made of Pt, Pd, W, an AuW alloy, Ta, a CuIr alloy, a CuBi alloy, a BiSb alloy, or a BiSe alloy. Such a plurality of stacked layers of paramagnetic metals may be, for example, a stacked body in which layers made of a plurality of types of paramagnetic metals are periodically stacked on each other (for example, when a layer made of a first paramagnetic metal is a layer D, a layer made of a second paramagnetic metal is a layer E, and a layer made of a third paramagnetic metal is a layer F, a stacked body is configured such that three types of layers are periodically stacked in the order of the layer D, the layer E, the layer F, the layer D, the layer E, the layer F, ...), or a stacked body in which layers made of a plurality of types of paramagnetic metals are randomly stacked on each other (for example, a stacked body is configured such that three types of layers are randomly stacked in the order of the layer D, the layer E, the layer F, the layer E, the layer D, the layer F, ...). It is preferable that the plurality of stacked layers of paramagnetic metals described above have spin Nernst angles of the same sign. This is because non-reciprocal voltage signals due to each of the plurality of layers of paramagnetic metals do not cancel each other out during energy conversion in the nonlinear response layer 402, thereby increasing the overall non-reciprocal voltage signal.

In the second embodiment described above, the nonlinear response layer 402 includes only one paramagnetic layer (paramagnetic layer 405) such as a paramagnetic metal layer (see FIGS. 7 and 8), but the nonlinear response layer 402 may include a first paramagnetic layer such as a paramagnetic metal layer and a second paramagnetic layer such as a paramagnetic metal layer. In this case, the nonlinear response layer 402 is configured by stacking the first paramagnetic layer, the ferromagnetic layer 403, and the second paramagnetic layer in this order in the Z-axis direction so that the ferromagnetic layer 403 is interposed between the first paramagnetic layer and the second paramagnetic layer. Preferred constituent materials of the first and second paramagnetic layers are the same as that of the paramagnetic layer 405, but it is preferable that the configurations (constituent materials, thicknesses, and the like) of the first and second paramagnetic layers be selected such that the nonlinear response layer 402 has a structure with broken spatial inversion symmetry in the Z-axis direction.

In this case, it is preferable that the first and second paramagnetic layers have spin Nernst angles of opposite signs. (For example, this can be achieved by forming the first paramagnetic layer of Pt and forming the second paramagnetic layer of Ta.) This is because, during energy conversion in the nonlinear response layer 402, spin currents with the same directional polarity are injected into the ferromagnetic layer 403 from each of the first and second paramagnetic layers, thereby increasing the number of non-reciprocal voltage signals.

Furthermore, in this case, each or either of the first and second paramagnetic layers may comprise a plurality of paramagnetic metal layers stacked as described above. In this case, it is preferable that the plurality of paramagnetic metal layers constituting each or either of the first and second paramagnetic layers have spin Nernst angles of the same sign for the reasons mentioned above.

In the second embodiment described above, the pair of electrodes 407a and 407b are provided on the surface 405S of the paramagnetic layer 405 (see FIGS. 7 and 8), but the pair of electrodes 407a and 407b may be provided on the back surface (the surface on the negative Z-axis side) of the ferromagnetic layer 403 so that they are not in contact with the paramagnetic layer 405 and are spaced apart from each other along the X-axis direction.

In the second embodiment described above, the ferromagnetic layer 403 and the paramagnetic layer 405 are stacked in this order on the substrate 401 to form the nonlinear response layer 402 (see FIGS. 7 and 8), but the nonlinear response layer 402 may be formed by stacking the paramagnetic layer 405 and the ferromagnetic layer 403 in this order on the substrate 401. In this case, the pair of electrodes 407a and 407b can be provided on the surface (the surface on the positive Z-axis side) of the ferromagnetic layer 403 or the back surface (the surface on the negative Z-axis side) of the paramagnetic layer 405 so that they are spaced apart from each other in the X-axis direction.

The fluctuation detection sensor of the present disclosure has the following configurations.
[1] A fluctuation detection sensor including:
   a nonlinear response part that has a nonlinear electrical response characteristic for an input of external energy in a first direction; and
   an electrode part for extracting an electrical response signal generated in the nonlinear response part due to an energy fluctuation input to the nonlinear response part from the outside in the first direction.
[2] The fluctuation detection sensor according to [1], in which the external energy is a current and/or a heat flux, and the energy fluctuation is a current fluctuation and/or a heat flux fluctuation.
[3] The fluctuation detection sensor according to [1] or [2], in which the external energy is a current, and the energy fluctuation is a current fluctuation.
[4] The fluctuation detection sensor according to any one of [1] to [3], in which the nonlinear response part has a configuration in which spatial inversion symmetry is broken in a second direction orthogonal to the first direction.
[5] The fluctuation detection sensor according to any one of [1] to [4], in which the nonlinear response part includes a ferromagnetic layer and a paramagnetic layer which are stacked on each other in the second direction.
[6] The fluctuation detection sensor according to any one of [1] to [5], in which the ferromagnetic layer is configured to be able to have spontaneous magnetization.
[7] The fluctuation detection sensor according to any one of [1] to [6], in which the ferromagnetic layer is a ferromagnetic metal layer and is made of an L1₀ type ordered alloy made of a magnetic metal and a paramagnetic metal, and the paramagnetic layer is a paramagnetic metal layer.

### Reference Signs List

200 Thermoelectric conversion element, 202 Thermoelectric conversion layer, 203 Ferromagnetic metal layer, 205 Paramagnetic metal layer, 207a, 207b Pair of electrodes.

## Claims

1. A thermoelectric conversion element comprising:
a thermoelectric conversion part that has a nonlinear thermoelectric response characteristic for an input of a heat flux along a first direction; and
an electrode part for extracting a thermoelectric signal generated in the thermoelectric conversion part due to the heat flux input to the thermoelectric conversion part from the outside along the first direction.

2. The thermoelectric conversion element according to Claim 1, wherein
the thermoelectric conversion part exhibits non-reciprocal conduction based on breaking of spatial inversion symmetry, and
the electrode part comprises a pair of electrodes for extracting non-reciprocal thermoelectric signals, the pair of electrodes being provided in the thermoelectric conversion part so as to be spaced apart from each other.

3. The thermoelectric conversion element according to Claim 2, wherein
the thermoelectric conversion part is a thermoelectric conversion layer including a ferromagnetic metal layer and a paramagnetic metal layer stacked on each other along a second direction orthogonal to the first direction, and
the pair of electrodes are provided in the thermoelectric conversion layer so as to be spaced apart from each other along the first direction in an in-plane direction of the thermoelectric conversion layer.

4. The thermoelectric conversion element according to Claim 2 or 3, wherein
a separation distance between the pair of electrodes is 0.1 µm or more and 1000 µm or less.

5. The thermoelectric conversion element according to Claim 3, wherein the paramagnetic metal layer includes a single layer or a plurality of stacked layers, and the single layer or each of the plurality of stacked layers of the paramagnetic metal layer comprises Pt, Pd, W, an AuW alloy, Ta, a CuIr alloy, a CuBi alloy, a BiSb alloy, or a BiSe alloy.

6. The thermoelectric conversion element according to Claim 3 or 5 or Claim 4 when dependent on Claim 3, wherein the ferromagnetic metal layer includes a single layer or a plurality of stacked layers, and the single layer or each of the plurality of stacked layers of the ferromagnetic metal layer comprises a Ni-Fe alloy, Fe, Co, Ni, Gd, a CoFeB alloy, or a (Ga,Fe)Sb alloy.

7. A thermoelectric conversion module comprising a plurality of the thermoelectric conversion elements according to any one of Claims 1 to 6, wherein the plurality of thermoelectric conversion elements are electrically connected to each other so that thermoelectric signals from the thermoelectric conversion elements are superimposed on each other with the same polarity.

8. A thermoelectric conversion method comprising:
a step of applying a temperature gradient including an AC component to a thermoelectric conversion part that exhibits non-reciprocal conduction based on breaking of spatial inversion symmetry; and
a step of generating, by the thermoelectric conversion part, a non-reciprocal thermoelectric signal by thermoelectrically converting the temperature gradient including the AC component.
